(19) **Europäisches Patentamt / European Patent Office / Office européen des brevets**

(11) **EP 1 892 763 A1**

(12) **EUROPEAN PATENT APPLICATION**
published in accordance with Art. 153(4) EPC

(43) Date of publication:
**27.02.2008 Bulletin 2008/09**

(51) Int Cl.:
**H01L 27/14** (2006.01)  **G02B 5/20** (2006.01)
**H04N 5/335** (2006.01)  **H04N 9/07** (2006.01)

(21) Application number: **06732575.3**

(22) Date of filing: **12.05.2006**

(86) International application number:
**PCT/JP2006/309594**

(87) International publication number:
**WO 2006/134740 (21.12.2006 Gazette 2006/51)**

(84) Designated Contracting States:
**AT BE BG CH CY CZ DE DK EE ES FI FR GB GR HU IE IS IT LI LT LU LV MC NL PL PT RO SE SI SK TR**

(30) Priority: **17.06.2005  JP 2005177990**
**26.07.2005  JP 2005215598**
**05.08.2005  JP 2005228517**
**05.08.2005  JP 2005228518**
**10.11.2005  JP 2005326173**

(71) Applicant: **Toppan Printing Co., Ltd.**
**Taito-ku,**
**Tokyo 110-0016 (JP)**

(72) Inventors:
• **OGATA, Keisuke**
**Toppan Printing Co. ltd**
**Tokyo 110-0016 (JP)**
• **KITAMURA, Satoshi**
**Toppan Printing Co. Ltd.**
**Tokyo 110-0016 (JP)**
• **FUKUYOSHI, Kenzo**
**Toppan Printing Co. Ltd.**
**Tokyo 110-0016 (JP)**

(74) Representative: **TBK-Patent**
**Bavariaring 4-6**
**80336 München (DE)**

(54) **IMAGING ELEMENT**

(57)   An imaging device (1) comprises a filter (2) used for extracting a specified color component of an incident light, and a light receiving element (3) observing the incident light via the filter (2). The filter includes a transparent filter (2W), a yellow filter (2Y) used for extracting a yellow component and a red filter (2R) used for extracting a red component.

FIG.4

**EP 1 892 763 A1**

**Description**

Technical Field

The present invention relates to an imaging device, which is excellent in color balance and color reproducibility.

Background Art

Conventionally, an image sensor (imager) used for digital and video cameras includes an imaging device. The imaging device is provided with a light receiving element, such as a CMOS or CCD, and a color filter, which are paired, and thereby, images a color image.

The light receiving element outputs an electrical signal in accordance with the intensity of incident light. The light receiving element senses the brightness only of the incident light, and does not determine the color thereof. And so, a side (hereinafter, referred to as incident light side) where light is incident on each light receiving device is provided with a color filter to extract light having a specified color component from the incident light. By doing so, the extracted color component light is observed via the light receiving element. Extracting light having a specified color component from the incident light is called as "color separation".

Specifically, the incident light side of the light receiving element is provided with color filters for light of three primary colors, that is, red (R), green (G) and blue (B). The incident light from an observed object is separated in colors via the color filters before reaching the light receiving element, and thereby, a specified light is extracted. The extracted light reaches the light receiving element facing each color filter, and then, is photo-electrically converted into an electrical signal. By doing so, an output value (usually, voltage value) of the three primary colors of the incident light is obtained. Then, the obtained output value is added, and thereby, the observed object is reproduced as a color image.

In general, the color filter is patterned into a necessary pattern in the following manner. Specifically, the color filter is developed using a developer after pattern exposure to a photosensitive resin via "photolithography process". The exposure system using the photolithography process includes a stepper, aligner, mirror projection aligner, etc. If high pixel and scale-down are required, the stepper is used.

Recently, for imaging devices, a demand as arisen for more pixels; as a result, the scale-down of pixel advances. Specifically, the pixel pitch becomes less than 3 μm, and as of today, about 2 μm. If a fine pixel having the pixel pitch of about 2 μm is given, an area per pixel becomes small. For this reason, the quantity of light incident on the light receiving element reduces. As a result, the sensitivity of the imaging device is reduced, and therefore, the image quality is reduced (a dark image is produced).

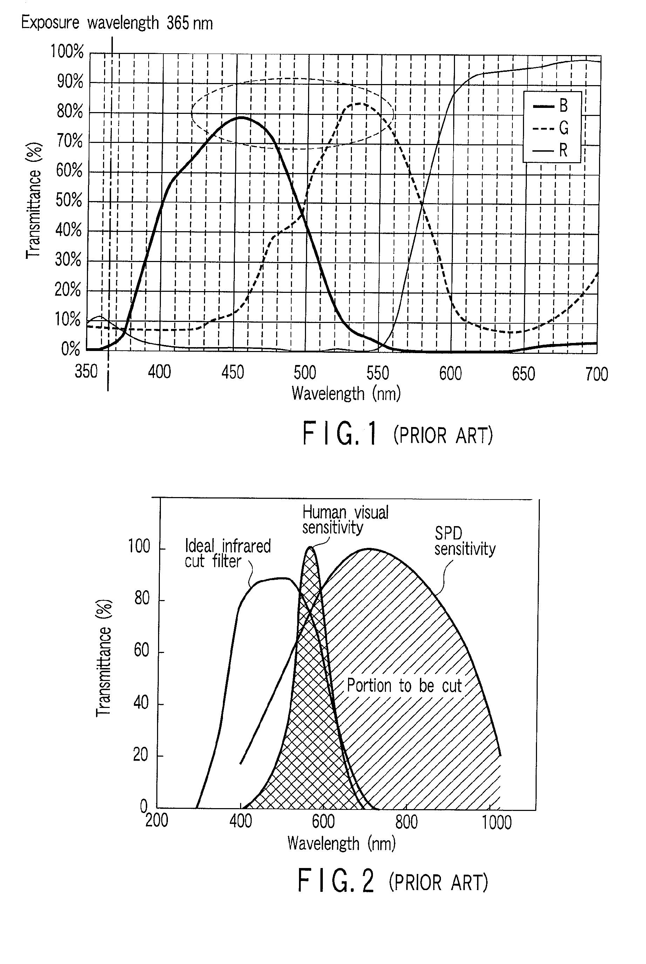

As described above, in the conventional imaging device, the incident light side of the light receiving element is provided with blue, green and red, that is, three primary color filters to separate the color of the light from the observed object. FIG. 1 shows one example of spectral transmittance of blue, green and red, that is, three primary color filters. In FIG. 1, the horizontal axis shows the wavelength while the vertical axis shows the transmittance. As seen from FIG. 1, the top portion of the transmittance of blue and green colors is a value before and after 80%. In other words, blue and green color filters each have low transmittance; for this reason, the quantity of light reaching the light receiving element is reduced. As a result, the image quality is reduced (a dark image is produced).

Light receiving elements such as a CMOS and CCD have a wide sensitivity range from about 400 nm to 1000 nm. In particular, as shown in FIG. 2, the SPD (Silicon Photo Diode) sensitivity of the light receiving element has a high value in the wavelength range of about 700 nm. In other words, the light receiving element has a high sensitivity in a red wavelength range (700 nm). However, the sensitivity is reduced in a short wavelength range. The sensitivity is about half of red in a blue wavelength range (400 nm to 500 nm).

As seen from the foregoing description, the sensitivity of the light receiving element is low in the blue range in the imaging device having blue, green and red primary color filters. In addition, the transmittance of the blue color filter is lower than that of red and green color filters.

For this reason, the conventional imaging device has the following problem. Specifically, blue reproducibility and color rendering is lower than red and green; as a result, color balance is not strictly reproducible.

In order overcome the foregoing problem, the following technique has been proposed (e.g., Jpn. Pat. Appln. KOKAI Publication No. 2002-51350). According to the technique, a complementary color filter comprising cyan (C), magenta (M) and yellow (Y) is used to prevent reduction of the quantity of light arriving at the light receiving element.

According to the technique, the yellow (Y) color filter is used, and thereby, composite light of red (R) and green (G) is extracted. The magenta (M) color filter is used, and thereby, composite light of red (R) and blue (B) is extracted. The cyan (C) color filter is used, and thereby, composite light of green (G) and blue (B) is extracted. In other words, the complementary color filter transmits light of two colors; therefore, this serves to increase the transmittance of light. By doing so, it is possible to prevent the quantity of light incident on the imaging device from being reduced.

Disclosure of Invention

However, troublesome operations are required to extract the three primary colors of light; blue, green and red from the light transmitted through cyan, magenta and yellow complementary color filters.

For example, the following calculations must be made based on an observed data value of each filter.

$$Blue = (cyan + magenta - yellow)/2$$

$$Green = (cyan + yellow - magenta)/2$$

$$Red = (magenta + yellow - cyan)/2$$

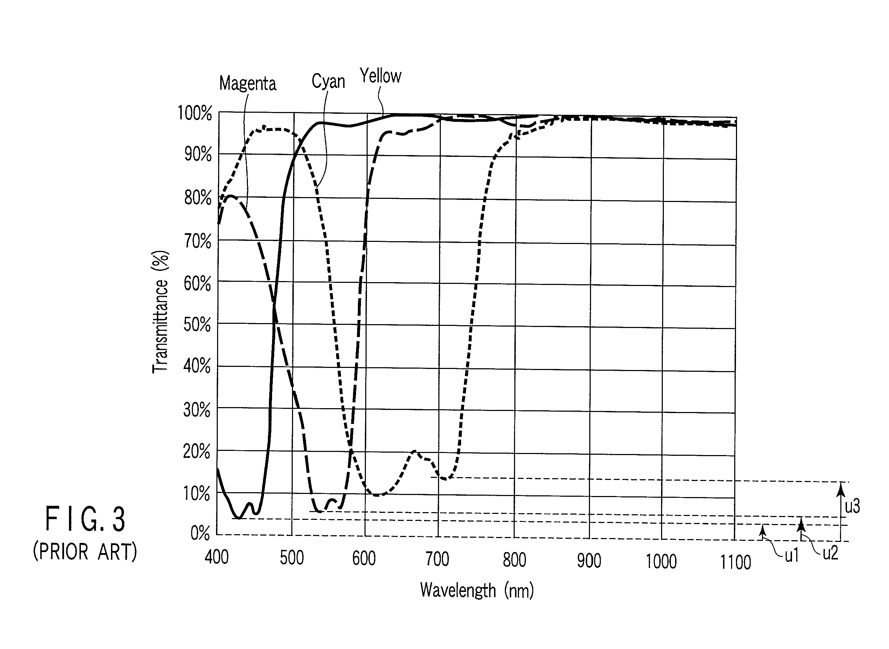

FIG. 3 is a graph showing spectral characteristics of general C, M and Y complementary color filters. As described above, the complementary color filters obtain an observed data value equivalent to the three primary colors using the operation. As seen from FIG. 3, the complementary color filters each transmit light belonging to a light wavelength range to be inherently shielded. As is evident from u1, u2, and u3 shown in FIG. 3, the transmittance of each complementary color filter is different for every color in the wavelength range to be inherently shielded. The foregoing difference is the factor of a noise component included in the operation resultant value.

For this reason, the imaging device using complementary color filters has a high sensitivity, but noise is increased. As a result, there is a problem that color reproducibility (color separation) is reduced as compared with three primary color filters.

The present invention has been made in view of the foregoing circumstances. An object of the present invention is to provide an imaging device, which is excellent in color balance and color reproducibility.

In order to solve the problem, the present invention provides an imaging device comprising:

a filter used for extracting a specified color component of an incident light; and
a light receiving element observing the incident light via the filter,
the filter including:
a transparent filter
a yellow filter used for extracting a yellow component; and
a red filter used for extracting a red component.

Brief Description of Drawings

FIG. 1 is a graph showing a spectral transmittance of a conventional imaging device;
FIG. 2 is a graph showing the relationship between wavelength and transmittance in human visual sensitivity, sensitivity (SPD sensitivity) of light receiving element and ideal infrared cut filter;
FIG. 3 is a graph showing spectral characteristics of general C, M and Y complementary color filters;
FIG. 4 is a top plan view showing a state that filters are arrayed in an imaging device 1 according to a first embodiment of the present invention;
FIG. 5 is a cross-sectional view showing the imaging device according to the first embodiment;
FIG. 6 is a graph showing each spectral transmittance of transparent filter 2W, yellow filter 2Y and red filter 2R according to the first embodiment;
FIG. 7 is a graph showing each spectral transmittance of virtual blue, green and red filters obtained by an operation of the imaging device 1 according to the first embodiment;
FIG. 8 is a graph showing spectral characteristics of a conventional imaging device;
FIG. 9 is a cross-sectional view showing an imaging device 9 according to a second embodiment of the present invention;
FIG. 10 is a cross-sectional view showing an imaging device 11 according to a third embodiment of the present invention;
FIG. 11 is a cross-sectional view to explain a process of manufacturing the imaging device 11 according to the third embodiment;

FIG. 12 is a cross-sectional view to explain the process of manufacturing the imaging device 11 according to the third embodiment;

FIG. 13 is a cross-sectional view to explain the process of manufacturing the imaging device 11 according to the third embodiment;

FIG. 14 is a cross-sectional view to explain the process of manufacturing the imaging device 11 according to the third embodiment;

FIG. 15 is a cross-sectional view to explain the process of manufacturing the imaging device 11 according to the third embodiment;

FIG. 16 is a top plan view showing an arrangement of a shield film o an imaging device 17 according to a fourth embodiment of the present invention;

FIG. 17 is a front view showing a state that filters are arrayed in an imaging device 31 according to a fifth embodiment of the present invention;

FIG. 18 is a cross-sectional view showing the imaging device 31 according to the fifth embodiment;

FIG. 19 is a cross-sectional view showing another imaging device 31 according to the fifth embodiment;

FIG. 20 is a graph showing spectral transmittance relevant to compensating filter 2Blk, transparent filter 2W, yellow filter 2Y and red filter 2R according to the fifth embodiment;

FIG. 21 is a graph showing each spectral transmittance of virtual blue, green and red filters obtained by an operation of the imaging device 31 according to the fifth embodiment;

FIG. 22 is a graph showing spectral characteristics of the compensating filter according to the fifth embodiment;

FIG. 23 is a graph showing spectral characteristics of a general absorption type infrared cut filter;

FIG. 24 is a cross-sectional view showing the imaging device 39 according to a sixth embodiment of the present invention;

FIG. 25 is a cross-sectional view showing the imaging device 41 according to a seventh embodiment of the present invention;

FIG. 26 is a font view showing a first arrangement of a shield film 19 of an imaging device 47 according to an eighth embodiment of the present invention;

FIG. 27 is a cross-sectional view showing the imaging device 47 according to the eighth embodiment;

FIG. 28 is a cross-sectional view a second arrangement of a shield film 19 of an imaging device 44 according to the eighth embodiment;

FIG. 29 is a graph showing spectral transmittance characteristics of a compensating filter according to a ninth embodiment of the present invention;

FIG. 30 is a graph showing spectral transmittance characteristics of a compensating filter according to a ninth embodiment;

FIG. 31 is a graph showing spectral characteristics of a compensating filter according to a tenth embodiment of the present invention;

FIG. 32 is a schematic view showing the configuration of an imaging device according to an 11th embodiment of the present invention;

FIG. 33 is a view to explain the concept of an arrayed state of a color filter of an imaging device 110 according to the 11th embodiment when viewing from the incident light side;

FIG. 34A is a cross-sectional view showing the imaging device 110 according to the 11th embodiment;

FIG. 34B is a cross-sectional view showing the imaging device 110 according to the 11th embodiment;

FIG. 35 is a flowchart to explain the operation of the imaging device 110 according to the 11th embodiment;

FIG. 36 is a graph showing the human eye stimulation value of light, which changes according to wavelength;

FIG. 37A is a view to explain a method of manufacturing an imaging device 110 according to a 12th embodiment of the present invention;

FIG. 37B is a view to explain the method of manufacturing the imaging device 110;

FIG. 37C is a view to explain the method of manufacturing the imaging device 110;

FIG. 37D is a view to explain the method of manufacturing the imaging device 110;

FIG. 38A is a view to explain the method of manufacturing the imaging device 110;

FIG. 38B is a view to explain the method of manufacturing the imaging device 110;

FIG. 38C is a view to explain the method of manufacturing the imaging device 110;

FIG. 38D is a view to explain the method of manufacturing the imaging device 110;

FIG. 38E is a view to explain the method of manufacturing the imaging device 110;

FIG. 39 is a view showing another imaging device according to the 12th embodiment;

FIG. 40 is a view showing another imaging device according to the 12th embodiment;

FIG. 41 is a schematic view showing the configuration of an imaging device according to a 13th embodiment of the present invention;

FIG. 42 is a view to explain the concept of an arrayed state of a color filter 114 of an imaging device 110T according to the 13th embodiment when viewing from the incident light side;

FIG. 43A is a cross-sectional view showing the imaging device 110T according to the 13th embodiment;

FIG. 43B is a cross-sectional view showing the imaging device 110T according to the 13th embodiment;

FIG. 44 is a cross-sectional view showing another imaging device 110T according to the 13th embodiment;

FIG. 45 is a graph showing the relationship between wavelength and transmittance in human visual sensitivity, sensitivity (SPD sensitivity) of light receiving element and ideal infrared cut filter;

FIG. 46 is a graph showing the relationship between light wavelength and transmittance in reflection and absorption type infrared cut filters;

FIG. 47 is a graph showing spectral characteristics of a planarization layer according to the first example of the present invention;

FIG. 48 is a graph showing spectral characteristics of transparent filter 114W, yellow filter 114Y, red filter 114R and compensating filter 114Blk according to the first example;

FIG. 49 is a graph showing each spectral characteristic of virtual blue, green and red filters obtained by an operation of the imaging device according to the first example;

FIG. 50 is a graph showing spectral characteristics of a transparent resin according to the second example of the present invention;

FIG. 51 is a graph showing spectral characteristics of transparent filter 114W, yellow filter 114Y, red filter 114R and compensating filter 114Blk according to the second example;

FIG. 52 is a graph showing each spectral characteristic of virtual blue, green and red filters obtained by an operation of the imaging device according to the second example;

FIG. 53 is a graph showing spectral characteristics of filters F1 to F7 according to a 14th embodiment of the present invention;

FIG. 54 is a view to explain the concept of virtual color filter according to the 14th embodiment;

FIG. 55 is a front view showing an imaging device according to a 15th embodiment of the present invention; and

FIG. 56 is a graph showing spectral characteristics of filters F1 to F7 according to the 15th embodiment.

Best Mode for Carrying Out the Invention

Various embodiments of the present invention will be hereinafter described with reference to the accompanying drawings. In the following description, the same reference numerals are used to designate the identical components, and the details thereof are omitted.

<First embodiment>

An imaging device according to the first embodiment will now be described. The imaging device is provided with a filter layer at a light incident side of a light receiving element, such as a CMOS or CCD, to observe a color component of an observed object.

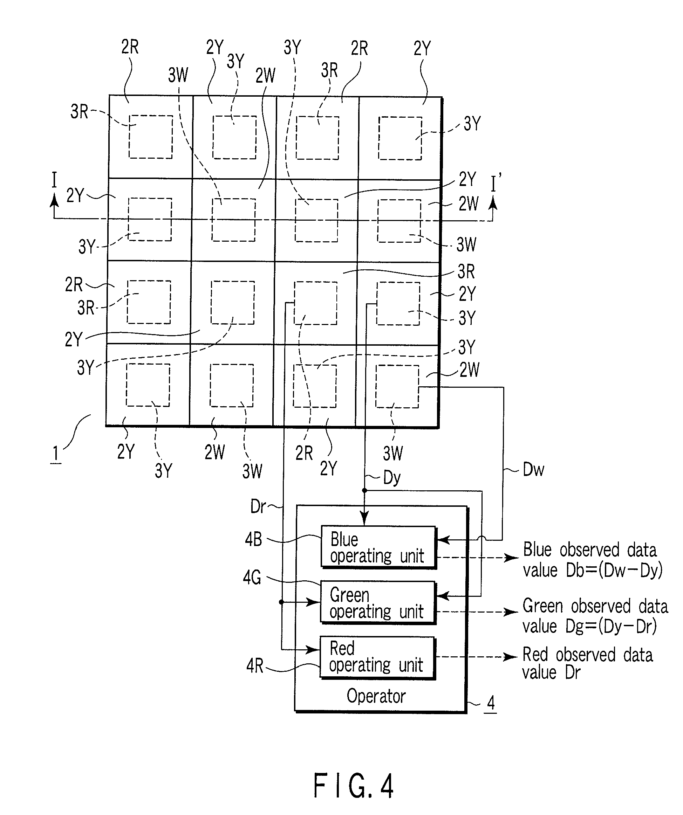

FIG. 4 is a top plan view showing a state that filters are arrayed in the imaging device according to the first embodiment. FIG. 4 shows a state that filters are arrayed when viewing from the light incident side.

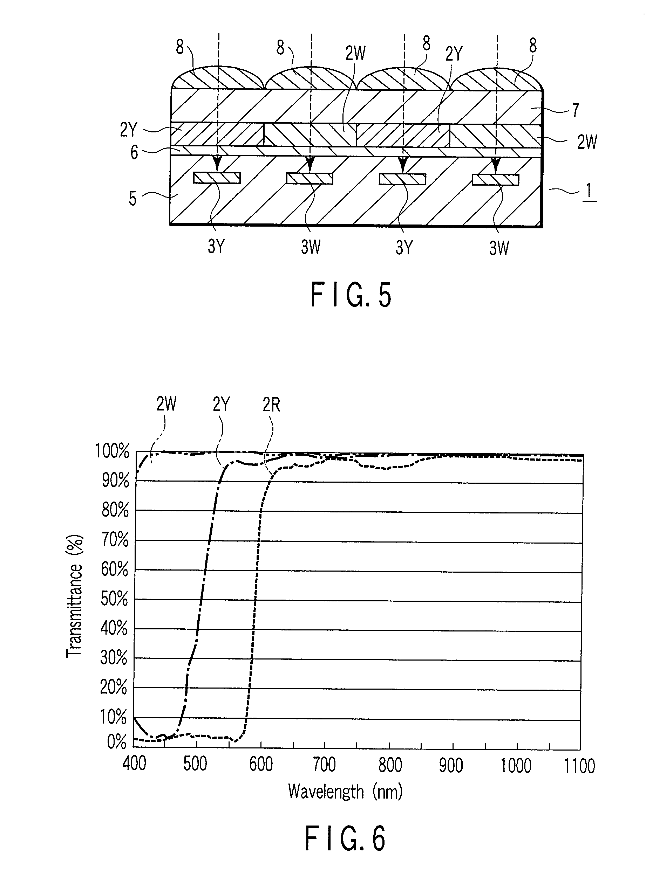

FIG. 5 is a cross-sectional view showing the imaging device according to the first embodiment. FIG. 5 shows a cross section taken along a line I-I' of FIG. 4. In FIG. 5, although there is shown the case where the light receiving element is a CMOS, a CCD may be used as the light receiving element. In the following description, the same configuration is given to other cross-sectional views of the imaging device.

An imaging device 1 includes filter layer 2, light receiving element 3 and an operator 4. The filter layer 2 is used for extracting a specified color component of incident light. The light receiving element 3 observes the incident light via the filter layer 2.

The filter layer 2 includes transparent filter 2W, yellow filter 2Y and red filter 2R. Two pixels are given as the yellow filter 2Y, and one pixel is given as each of transparent and red filters 2W and 2R. Thus, one unit of color separation is formed of the total of four pixels. In other words, the number of the pixels of the yellow filter 2Y is equal to the total number of pixels of transparent and red filters 2W and 2R. By ding so, operations such as {(white) - (yellow)} and {(yellow) - (red)} described later are carried out for every unit.

The foregoing transparent filter 2W, yellow filter 2Y and red filter 2R are arrayed adjacently like a mesh to form a plane.

Preferably, the transparent filter 2W transmits light without absorbing mainly a long wavelength light of 400 nm or more. In other words, the transparent filter 2W transmits light synthesizing blue, green and red components. For example, a filter satisfying the following conditions is preferably given as the transparent filter 2W. According to the conditions, a transparent glass having a refraction n of about 1.5 is used as a reference, and the transmittance of the light having a wavelength of 400 nm or more is 95% or more. The transparent filter 2W is formed of phenol, polystyrene or acrylic resin. In this case, the transparent filter 2W is formed of polystyrene, preferably, acrylic resin. This is preferable in view of heat resistance.

The yellow filter 2Y is a filter used for extracting a yellow component of incident light (light synthesizing red and green components). Moreover, the yellow filter 2Y is a complementary color filter. In general, a complementary color filter has a higher transmittance than a blue, green, red, three primary color filter.

The red filter 2R is a red color filter used for extracting a red component of the incident light. In general, a red color filter has a higher transmittance than other color filters of three primary colors, that is, blue and green color filters.

The light receiving element 3 is arranged at the side opposite to the light incident side of the filter layer 2. The light receiving element 3 includes incident light receiving element 3W, yellow light receiving element 3Y and red light receiving element 3R. Moreover, the light receiving element 3 has a function of receiving light via the filter layer 2 and converting the received light into an electrical signal to calculate an observed data value (intensity value). The one-to-one combination of the light receiving element and the filter is equivalent to a pixel. The light receiving element 3 is formed at the incident light side of a semiconductor substrate 5.

The incident light receiving element 3W is formed corresponding to transparent filter 2W to observe an incident light via the transparent filter 2W.

The yellow light receiving element 3Y is formed corresponding to the yellow filter 2Y to observe the incident light via the yellow filter 2.

The red light receiving element 3R is formed corresponding to the red filter 2R to observe the incident light via the yellow filter 2R.

The operator 4 includes blue, green and red operating units 4B, 4G and 4R. The operator 4 further has a function of calculating the following data. Based on observed data values Dw and Dy taken by the foregoing incident light, yellow and red receiving elements 3W, 3Y and 3R, blue and green observed data values Db and Dg are determined.

The blue operating unit 4B subtracts the observed data value Dy observed by the yellow light receiving element 3Y from the observed data value Dw observed by the incident light receiving element 3W. Thus, the operating unit 4B determines the blue observed data Db (= Dw - Dy).

The green operating unit 4G subtracts the observed data value Dr observed by the red light receiving element 3R from the observed data value Dy observed by the yellow light receiving element 3Y. Thus, the green operating unit 4G determines the green observed data Dg (= Dy - Dr).

Namely, if white (W), Yellow (Y) and red (R) are given as each of colors corresponding to transparent, yellow and red filters 2W, 2Y and 2R, the following equations (1) and (2) are established.

$$\text{Blue (B) = white (W) - yellow (Y)} \quad \dots \text{(1)}$$

$$\text{Green (G) = yellow (Y) - red (R)} \quad \dots \text{(2)}$$

FIG. 5 shows a cross section ranging yellow and transparent filters 2Y and 2W and yellow and transparent light receiving elements 3Y and 3W. Other filters and light receiving elements each have the same cross-sectional structure as described above.

The light receiving side of the semiconductor substrate 5 is formed with the light receiving element 3.

A planarization layer 6 is stacked on the surface of the light incident side of the semiconductor substrate formed with the light receiving element 3. A resin containing one or more of acryl, epoxy, polyimide, urethane, melamine, polyester, urea and styrene is usable as the material for the planarization layer 6.

The light incident side of the planarization layer 6 is formed with the filter layer 2 corresponding to the light receiving element 3. Moreover, a resin layer (transparent planarization layer) 7 is stacked on the light incident side of the filter layer 2.

The light incident side of the resin layer 7 is provided with a micro lens 8 corresponding to the light receiving element 3.

A micro lens 8 is arranged above each of transparent, yellow and red filters 2W, 2Y and 2R to make a pair with each of these filters. Moreover, the micro lens 8 is formed of acrylic resin to improve convergence to incident light, yellow and red receiving elements 3W, 3Y and 3R.

According to the first embodiment, each filter layer has a film thickness of 1.4 $\mu$m, and a pixel pitch (of transparent, yellow and red filters 2W, 2Y, 2R) is 2.6 $\mu$m.

An ultraviolet absorbing agent is added to the foregoing planarization layer 6. Specifically, the planarization layer 6 is formed of a thermosetting acrylic resin added with an ultraviolet absorbing agent, and formed to have a film thickness of 0.3 μm. Adding the ultraviolet absorbing agent to the planarization layer 6 is done for the following reason. Namely, when the filter layer 2 is formed using the photolithography process, halation of a pattern exposure light from the front-end, that is, the semiconductor substrate 5 is prevented. By doing so, a filter having a good shape is obtained. Here, pattern exposure and development are made with respect to a photosensitive resin layer using the photolithography process so that a photosensitive resin remains at a predetermined portion.

According to the first embodiment, the planarization layer 6 is formed. In this case, no planarization layer 6 may be formed for the purpose of making the imaging device thinner.

According to the first embodiment, the transparent filter 2W is formed of an alkali-soluble photosensitive acrylic resin (refraction n = 1.55).

Yellow filter 2Y and red filter 2R are formed of a colored photosensitive resin described below. The colored photosensitive resin is formed in a manner of adding and dispersing a predetermined organic pigment to the transparent resin (photosensitive acrylic resin) used for forming the transparent filter 2W. For example, C.I. Pigment Yellow 150 may be used as an organic pigment for forming the yellow filter 2Y. In addition, a pigment mixing C.I. Pigment Yellow 150 with C.I. Pigment Yellow 139 is usable. Moreover, a pigment mixing C.I. Pigment Red 177, C.I. Pigment Red 48:1 and C.I. Pigment Yellow 139 may be used as an organic pigment for forming the red filter 2R. Incidentally, the transparent filter 2W may be formed of a transparent resin to which no colored pigment is added.

FIG. 6 is a graph showing spectral transmittance of transparent, yellow and red filters 2W, 2Y and 2R.

The imaging device 1 performs an operation (subtraction) based on observed data values Dw, Dy and Dr observed by each light receiving element. By doing so, for the three primary colors, that is, blue, green and red, observed data values Db, Dg and Dr are obtained. In other words, the imaging device 1 performs the operation described above, and thereby, seemingly (virtually) includes blue and green filters.

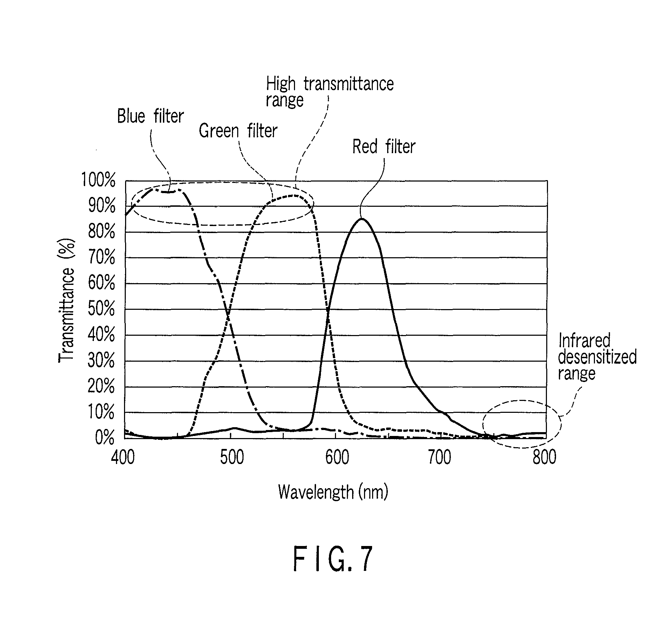

FIG. 7 is a graph showing spectral transmittance of virtual blue, green and red filters obtained by the operation of the imaging device 1. When comparing the graph of FIG. 7 with the spectral transmittance of the conventional blue and green color filters, it can be seen that the spectral transmittance of virtual blue and green filters of the imaging device 1 is higher than that of the conventional blue and green color filters. In particular, the transmittance of the virtual blue filter is higher than the conventional blue color filter. Therefore, the imaging device 1 according to the first embodiment has high blue sensitivity; as a result, color balance is excellent.

A comparison between the imaging device 1 according to the first embodiment and the conventional imaging device will be hereinafter described.

First, a "virtual color filter" will be described below.

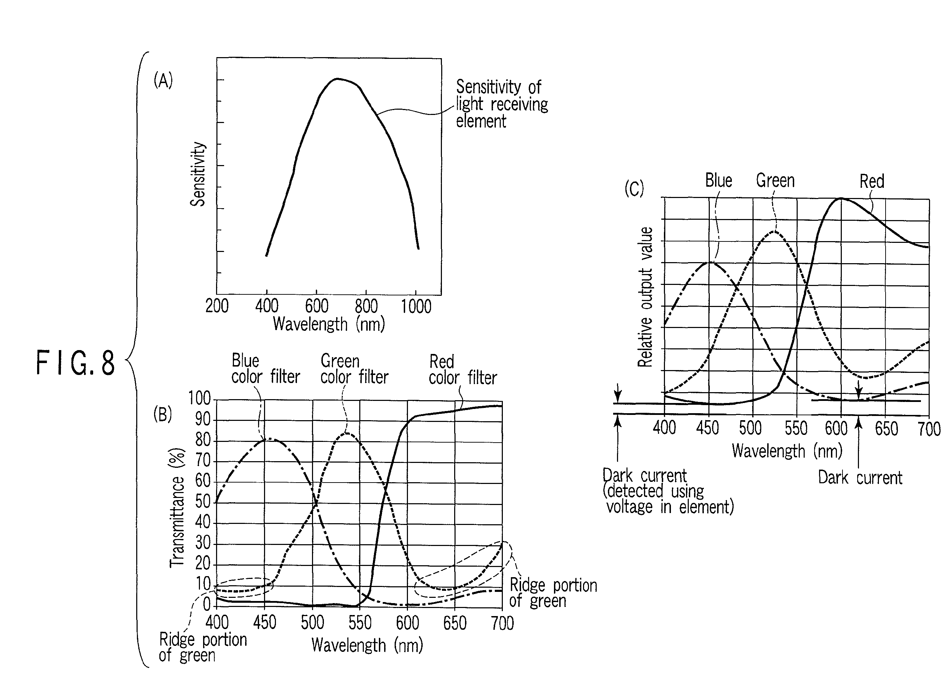

FIG. 8 is a graph showing spectral characteristics of the conventional imaging device.

The spectral characteristics of the conventional imaging device are equivalent to the product value obtained in the following manner. The product value is obtained from multiplying the sensitivity of light receiving element (graph (A) of FIG. 8) by the transmittance of filters arranged on the light incident side of the light receiving element (graph (B) of FIG. 8). The result is expressed as shown in a graph (C) of FIG. 8.

As shown in the graph (B) of FIG. 8, the blue color filter of the conventional imaging device has a transmittance lower than the red and green color filters. As seen from the graph (A) of FIG. 8, the sensitivity of the light receiving element in the blue wavelength range is lower than that in the red and green wavelength ranges. For this reason, when the sensitivity ratio of the conventional imaging device is calculated, the ratio of (blue/green) becomes smaller than that of (red/green). This is a factor which reduces color reproducibility.

On the contrary, the imaging device 1 according to the first embodiment has the following features. Specifically, transparent, yellow and red filters 2W, 2Y and 2R are provided in place of three primary colors, that is, red, green and blue color filters. Therefore, the spectral characteristics of the imaging device 1 according to the first embodiment are equivalent to a product value obtained in the following manner. The product value is obtained from multiplying the sensitivity of light receiving element by the transmittance of transparent, yellow and red filters 2W, 2Y and 2R arranged on the light incident side of the light receiving element. The transmittance of transparent, yellow and red filters 2W, 2Y and 2R is higher than that of the blue and green color filters. Therefore, incident, yellow and red light receiving elements 3W, 3Y and 3R observe an incident light via transparent, yellow and red filters 2W, 2Y and 2R. In this case, observed data values Db and Dg calculated based on observed data values Dw, Dy and Dr are the observation result obtained from high transmittance. In particular, according to the blue observed data value Db, the sensitivity ratio of (blue/green) is made high; therefore, color reproducibility is improved.

According to the first embodiment, blue and green observed data values Db and Dg are calculated using one-time subtraction only. Therefore, this serves to simplify the operation as compared with the imaging device using the conventional complementary color filter. As a result, vivid colors close to primary colors are reproducible.

The following is an explanation about "noise resulting from dark current".

As seen from the graph (C) of FIG. 8, the light receiving element generates a small current even if no light is incident thereon. Even though light is not incident on the element, the current flowing from the light receiving element is called "dark current", which is a factor generating noise. Conventional blue, green and red, that is, three primary color filers transmit light having a predetermined wavelength range on spectral characteristics, and there exists a wavelength range shielding light.

However, the light receiving element generates a dark current in the wavelength range of shielding light. For this reason, the observed result of the conventional imaging device includes the noise resulting from the dark current in addition to the observed result of light in the wavelength range of transmitted light. Thus, there is a possibility that color reproducibility is reduced resulting from the noise.

On the contrary, the imaging device 1 according to the first embodiment performs the following operations, that is, subtractions described above. Specifically, the observed data value Dy of the yellow light receiving element 3Y is subtracted from the observed data value Dw of the incident light receiving element 3W. Moreover, the observed data value Dr of the red light receiving element 3R is subtracted from the observed data value Dy of the yellow light receiving element 3R. By doing so, a dark current value is offset. Thus, the noise is removed from the observed result; therefore, color reproducibility is improved.

The following is an explanation about "spectral peaks and troughs".

The spectral transmittance of the conventional blue, green and red color filters is seen from the graph (B) of FIG. 8. The transmittances of the ridge portions of the spectral curves of blue and red color filters are low, that is, several percent (%). On the other hand, the transmittance of the ridge portion of the spectral curve of the green color filter is high, that is, about 10%. As described above, the transmittance of the ridge portion of the curve is high, and this means that spectral peaks and troughs are large.

The conventional imaging device has the following features. The ridge portion of the spectral curve of the green color filter exists in blue and red wavelength range. The spectral peaks and troughs of the ridge portion of green are large. For this reason, the green observed result mixes blue and red color; as a result, there is problem that green color reproducibility is reduced.

On the contrary, the imaging device according to the first embodiment performs the following operation to calculate the green observed data value Dg. Specifically, the observed data value Dr of the red light receiving element 3R is subtracted from the observed data value Dy o the yellow light receiving element 3Y. Thus, the spectral peaks and troughs are made small; therefore, this serves to improve color reproducibility.

The following is an explanation about the "ultraviolet and infrared absorbing agent".

The light receiving element, such as a CMOS or CCD, has a slight sensitivity with respect to an ultraviolet range that humans cannot sense. For this reason, the following features are desired. Specifically, the filter layer 2 of the first embodiment absorbs light of 400 nm or less so as not to transmit it. On the other hand, the filter layer 2 transmits light of 400 nm or more without absorbing it. In order to achieve the foregoing features, an ultraviolet absorbing agent, an initiator used for resin thermosetting and hardener are added to the transparent filter 2W. By doing so, the transparent filter 2W has an ultraviolet absorbing function. For example, benzotriazole, benzophenone compound, salicylic acid and coumarin compounds are usable as the ultraviolet absorbing agent. Moreover, a light stabilizer such as hinderdomine and quencher may be added to the ultraviolet absorbing agent. A functional group having the ultraviolet absorbing function is pendent to a resin used for forming the transparent filter 2W, that is, a polymer, monomer or hardener. A group incorporated into polymer may be polymerized. For example, quinone and anthracene may be introduced into a polymer, or a monomer having an ultraviolet absorbing group may be added. The foregoing pendent means that a reactive absorber is incorporated into a resin molecular chain.

More preferably, an infrared absorptive compound and infrared absorbing agent are added to a resin forming the transparent filter 2W. For example, according to the foregoing pendent, they are added to the resin forming the transparent filter 2W.

Moreover, the filter layer 2 of the first embodiment has the following features. Two pixels are used as the yellow filter 2Y, and one pixel is used as each of transparent and red filters 2W and 2R. Thus, one unit of color separation is formed using four pixels in total. Therefore, when the operator 4 obtains blue and green observed values, the yellow data value does not need to be repeatedly used. In other words, the operator 4 independently executes the operations of {(white) - (yellow)} and {(yellow) - (red)} in one unit. This serves to realize a high-speed operation.

As described above, the imaging device 1 according to the first embodiment performs one-time subtraction. By doing so, the imaging device 1 includes virtual high-transmittance blue and green filters. Thus, blue observation accuracy is improved as compared with the conventional imaging device.

<Second embodiment>

The second embodiment relates to a modification example of the imaging device 1 according to the first embodiment. An imaging device 9 according to the second embodiment differs from the imaging device 1 according to the first embodiment in the following point. That is, the transparent filter 2W and the resin layer 7 are integrated. The same reference numerals are used to designate portions the same as already described, and a repeated explanation is omitted.

In the following embodiments, overlapping explanations are omitted, likewise.

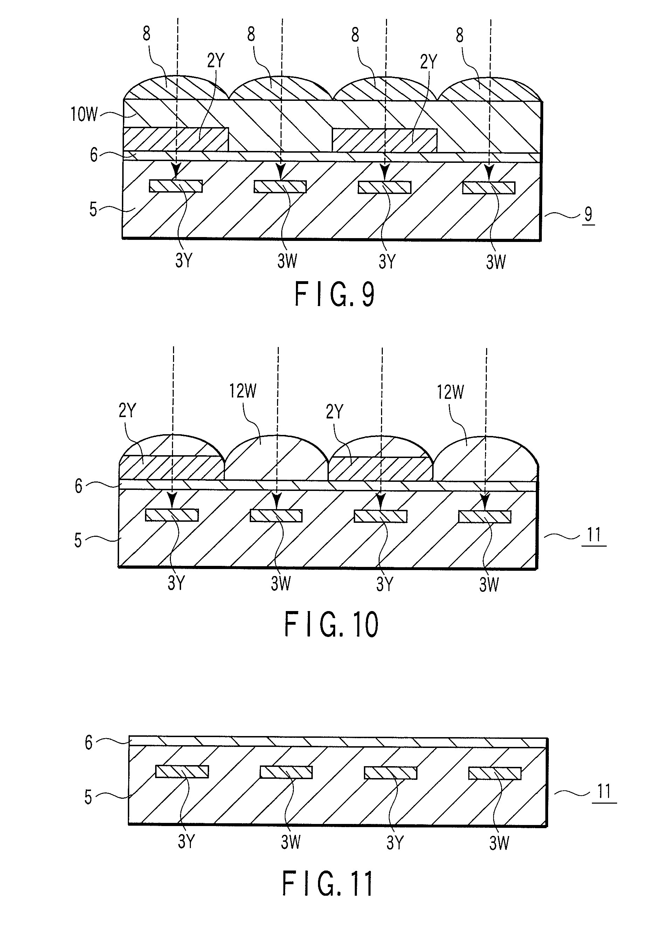

FIG. 9 is a cross-sectional view showing the imaging device according to the second embodiment. FIG. 9 shows a cross section taken along a line I-I' of FIG. 4. A transparent filter 10W is equivalent to the transparent filter 2W and the resin layer 7 described in the first embodiment.

The imaging device 9 of the second embodiment has a structure in which part of the transparent filter 10W is arranged at the transparent filter 2W of the first embodiment.

Other portions of the transparent filter 10W cover the surface on the light incident side of yellow and red filters 2Y and 2R. In other words, the transparent filter 10W has a structure in which the transparent filter 2W and the resin layer 7 of the first embodiment are integrated. In addition, the transparent filter 10W also performs a function as a transparent planarization layer.

Like the first embodiment, the imaging device 9 performs an operation (subtraction) based on observed data values Dw, Dy and Dr obtained by each light receiving element 3 to obtain blue and green data values Db and Dg. In other words, the imaging device 9 performs an operation (subtraction) based on observed data values obtained by each light receiving element 3. By doing so, the imaging device 9 includes virtual blue, green and red filters.

The spectral transmittance of virtual blue, green and red filters obtained by the operation of the imaging device 9 is the same as that in FIG. 7 in a wavelength range from 400 nm to 800 nm.

According to the second embodiment, yellow and red filters 2Y and 2R are formed, and thereafter, the transparent filter 10W is formed to cover these filters. In this case, the transparent filter 10W is formed integrally with the transparent planarization layer.

In other words, the process of forming the transparent filter 10W and the transparent planarization layer is simultaneously carried out. Therefore, there is no need of independently providing a process of forming a pattern of the transparent filter. This contributes to simplifying the process of manufacturing the imaging device 9.

Specifically, the transparent planarization layer, that is, part of the transparent filter 10W is arranged at the position formed with the transparent filter 2W. Thus, the transparent filter 10W performs a function as the transparent planarization layer. Therefore, this serves to omit a process of independently forming the transparent filter using the photolithography process. In other words, three color filters are formed via the process of forming two color (yellow, red) filters. Therefore, a process of forming one color filter is reduced.

<Third embodiment>

The third embodiment relates to a modification example of the imaging device according to the first and second embodiments.

FIG. 10 is a cross-sectional view showing an imaging device according to the third embodiment.

An imaging device 11 of the third embodiment includes a transparent filter 12W. The transparent filter 12W has a structure in which the micro lens 8 and the transparent filter 10W of the imaging device 9 of the second embodiment are integrated. In other words, the transparent filter 12W has a function of enhancing convergence to incident, yellow and red light receiving elements 3W, 3Y and 3R.

The process of manufacturing the imaging device 11 will be hereinafter described with reference to FIG. 11 to FIG. 15.

At first, a semiconductor substrate 5 is formed with incident, yellow and red light receiving elements 3W, 3Y and 3R. A planarization layer 6 formed of a transparent resin is formed on the semiconductor substrate 5 (FIG. 11). Specifically, a coating liquid using an acrylic resin as a main component is applied on the semiconductor substrate 5 provided two-dimensionally with light receiving elements using spin coating at a rotational speed of 2000 rpm. Then, a heat treatment of 200°C is carried out to harden the film, and thereby, the planarization layer 6 having a film thickness of 0.2 $\mu$m is formed. The used acrylic resin coating liquid is doped with a coumarin ultraviolet absorbing agent having a solid ratio of about 3%.

In order to form color filters consisting of a colored photosensitive resin, an ultraviolet ray is used to expose the pattern on the colored photosensitive resin. In the pattern exposure, halation occurs. In order to prevent halation, it is desirable to add an ultraviolet absorbing agent to the planarization layer 6. In this case, no planarization layer 6 may be formed, to make the imaging device 11 thinner.

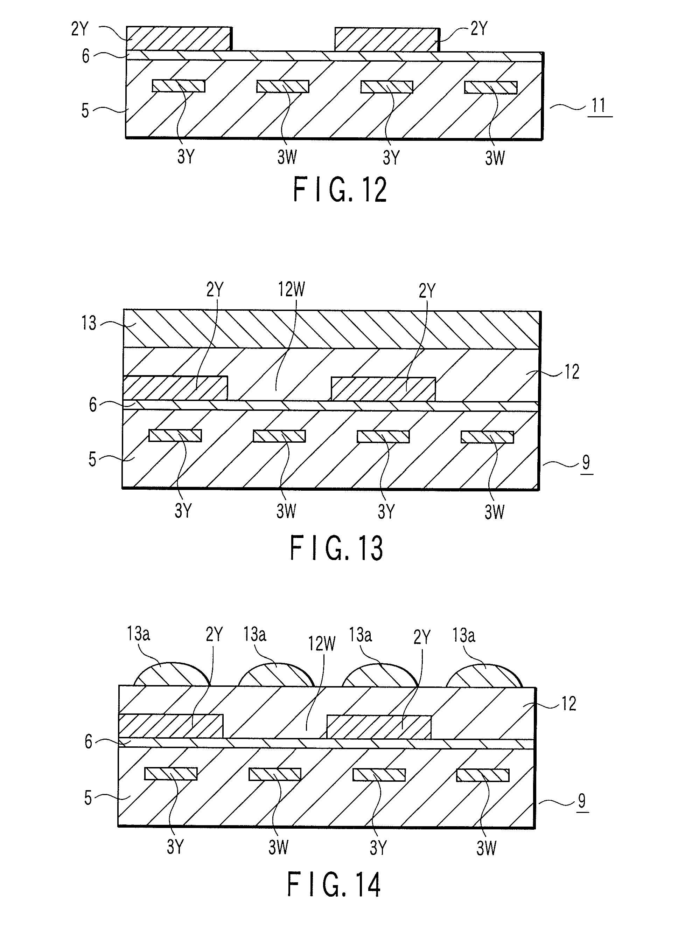

Thereafter, yellow and red filters 2Y and 2R are formed using the photolithography process (FIG. 12).

Specifically, yellow and red filters 2Y and 2R having a thickness of about 1 $\mu$m are formed using two color resists (yellow, red) mixed in with the color material in an exposable and developable photosensitive acrylic resin. An organic pigment C.I. Pigment Yellow 150 is usable as the color material of the yellow filter 2Y. The color material (organic pigment) of the yellow filter 2Y has a solid ratio of about 33%. A pigment mixing C.I. Pigment Red 177, C.I. Pigment Red 48:1 and C.I. Pigment Yellow 139 is usable as the color material of the red filter 2R. The color material (organic pigment) of the red filter 2R has a solid ratio of about 48%.

A transparent resin layer is coated on the semiconductor substrate 5 using spin coating to cover yellow and red filters 2Y and 2R. Then, the transparent resin layer is thermally hardened at a temperature of 180°C for three minutes to form a planarization layer 12 including a transparent filter 12W. The planarization layer 12 uses substantially the same material as the planarization layer 6. The planarization layer 12 is formed by coating a thermosetting acrylic resin having a high solid ratio for making the film thick. Incidentally, the acrylic resin contains a coumarin ultraviolet absorbing agent of 2%. The planarization layer 12 has a film thickness of about 2 $\mu$m.

Thereafter, an exposable and developable photosensitive phenol resin layer 13 is formed on the planarization layer 12 (FIG. 13). The photosensitive phenol resin layer 13 is a resin having "thermal reflow". Thermal reflow refers to the property in which the resin is melted by heat treatment, and then, rounded like a lens by surface tension.

Then, the photosensitive phenol resin layer 13 is formed with a photosensitive phenol resin having a predetermined pattern by carrying out pattern exposure development and film hardening.

A heat treatment of 200°C is carried out to fluidize the photosensitive phenol resin having a predetermined pattern. By doing so, a semi-spherical lens material (matrix) 13a having a thickness of about 0.6 $\mu$m is formed (FIG. 14).

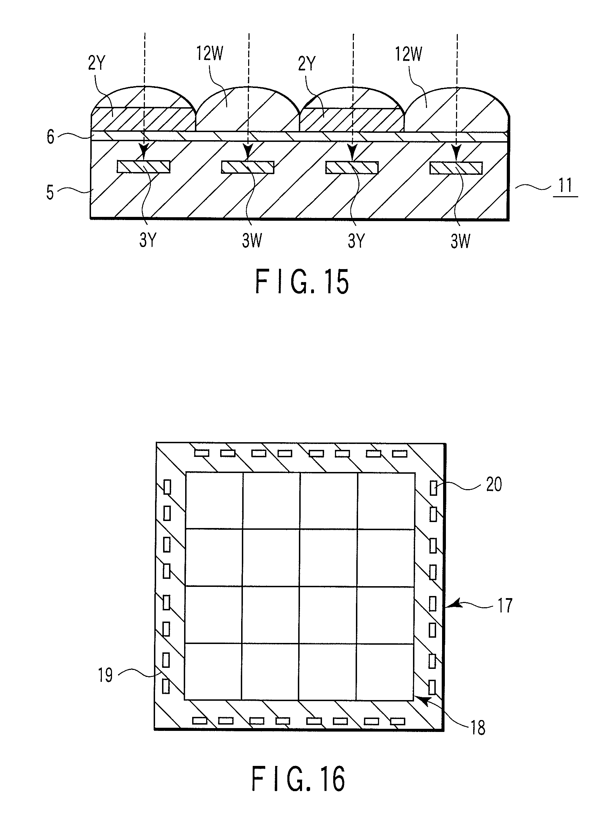

Anisotropic dry etching is carried out using the lens material 13a as a mask. By doing so, the shape of the lens material 13a is transferred to the planarization layer 12 to form a micro lens (FIG. 15). In other words, the lens material 13a is removed by the foregoing etching; however, the lens material 13a is used as the mask for the transparent filter 12W. Thus, the semi-spherical shape of the lens material 13a is transferred to the transparent filter 12W. In this manner, the micro lens 8 and the transparent filter 12W are simultaneously formed. In this case, dry etching (etching depth) is about 1 $\mu$m. Moreover, yellow and red filters 2Y and 2R are formed having a substantially film thickness of 1.2 $\mu$m as the etching depth to the surface.

As seen from the foregoing description, there is obtained the imaging device 11 in which part of the transparent filter 12W functions as a micro lens. The transparent filter 12W and the micro lens are formed integrally; therefore, the imaging device 11 can be made thinner.

According to the third embodiment, the transparent filter 12W having a function as a transparent planarization layer is formed into the shape of the micro lens. However, the transparent filter 12W having a function as a transparent planarization layer may be intactly formed without forming the micro lens. In this case, the transparent filter 12W is formed in the third process of FIG. 13, and thereafter, processes after the process of forming the photosensitive phenol resin 13 are not carried out.

As described above, preferably, the ultraviolet absorbing agent is added to the planarization layer 6 to prevent halation occurring in the pattern exposure of the colored photosensitive resin.

Moreover, preferably, the ultraviolet absorbing agent is added to the transparent filter 12W to prevent the generation of noise resulting from ultraviolet rays. This is because the light receiving element has sensitivity in the ultraviolet range.

Fine grains consisting of a metal oxide, such as cerium oxide and titanium oxide, are used as the ultraviolet absorbing agent. However, as described above, the lens shape is transferred to the transparent filter 12W, and thus, the transparent filter 12W functions as a transferred type micro lens. In this case, if the ultraviolet absorbing agent consists of fine grains of a metal oxide, an inorganic material becomes optical foreign matter in the resin of the transferred lens. For this reason, there is a possibility that light is shielded; as a result, an image obtained by the imaging device has a blacked-out portion. Therefore, it is preferable to use a dye ultraviolet absorbing agent. For example, any of benzo-triazole, benzo-phenone, triazine, salicylate, coumarin, xanthene, and a methoxyl arsenic acid compound may be used as the ultraviolet absorbing agent.

According to the first to third embodiments, yellow may be used as an under color other excepting transparent portions. In other words, yellow may be contained in common to red portions excepting transparent portions. In this case, the yellow filter 2Y is formed using a yellow resin while it is formed at the position formed with the red filter. Thereafter, the red filter 2R is formed at the position formed with the red filter.

<Fourth embodiment>

The fourth embodiment relates to an imaging device that is provided with a light shield film (antireflection filter). The light shield film is used for preventing reflection, diffusion and diffraction resulting from light other than the incident light incident on the light receiving elements.

FIG. 16 is a top plan view showing the layout of a light shield film of an imaging device according to the fourth embodiment. An imaging device 17 shown in FIG. 16 includes a light shield film 19 for preventing reflection and transmission of light. The light shield film 19 is arranged at the light incident side of the light receiving element, and at the outer periphery of an effective pixel part 18 provided with the filter layer 2. The imaging device 17 has an electrode 20 comprising aluminum for making external electric connections. The electrode 20 is formed with no light shield film 19.

A resin liquid dispersing and mixing the organic pigments given below is usable as the color material of the light shield film 19. For example, C.I. Pigment violet 23 and C.I. Pigment Red 177, C.I. Pigment ref 48:1, C.I. Pigment Yellow 139 are given. The foregoing color material is applied and hardened, and thereby, the light shield film 19 is formed. However, the color material is not limited to above, and other pigments may be used. The light shield film may be a single layer, or a layer stacking different colors.

The light shield film 19 is arranged at the outer periphery of the effective pixel part 18 of the imaging device 17. By doing so, it is possible to prevent the observed result of the imaging device 17 from being affected by noise. As a result, the image quality is enhanced.

In addition, in a conventional imaging device, stray light may enter the imaging device. This means that light incident on portions other than the light receiving elements strays into the imaging device. If such light is incident on the light receiving element, this is a factor causing noise. Moreover, if unnecessary light is incident on the peripheral region of the light receiving element, this is also a factor causing noise.

On the contrary, the imaging device 17 of the fourth embodiment is provided with the light shield film 19 at the effective opening periphery of the light receiving element and in part of the semiconductor substrate (e.g., outer periphery thereof). The light shield film has the characteristic of preventing transmission in the visible light wavelength range. Thus, the light shield film 19 absorbs light incident on portions other than the light receiving elements. By doing so, it is possible to prevent unnecessary light, such as stray light, from being incident on the light receiving elements. In other words, noise is reduced; therefore, the image quality obtained by the imaging device 17 can be enhanced.

According to the fourth embodiment, preferably, the light shield film 19 has a function of cutting infrared rays, in addition to the function of cutting visible light. The function of cutting infrared rays is realized in the following manner. Specifically, the light shield film 19 is formed to have a thickness of 0.8 $\mu$m using a resin liquid mixed with a black pigment, such as carbon black, at a solid ratio 40%.

Moreover, an absorption layer absorbing infrared and ultraviolet rays may be stacked on the light shield film 19 using a black pigment such as carbon black. By doing so, it is possible to prevent noise resulting from stray light caused by infrared and ultraviolet rays being incident on portions other than the light receiving elements. Infrared and ultraviolet absorbing agents are added to the transparent resin used for forming the micro lens 8. This agent is used as an absorption film absorbing infrared and ultraviolet rays. This serves to reduce the material cost.

According to the fourth embodiment, the imaging device 1 of the first embodiment is provided with the light shield film 19 and the absorption film. The imaging devices of other embodiments may be provided with the light shield film 19 and the absorption film. The imaging device may also be solely provided with the light shield film 19. Moreover, ultraviolet and infrared absorbing agents may be added to the light shield film 19.

<Fifth embodiment>

The fifth embodiment relates to an imaging device 31 in which the imaging device 1 of the first embodiment is additionally provided with a compensating filter 2Blk.

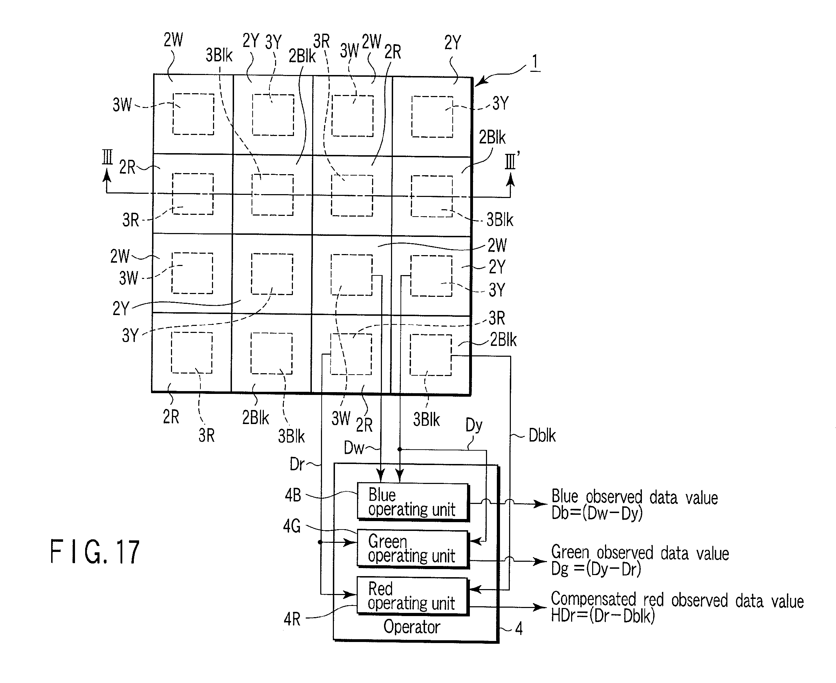

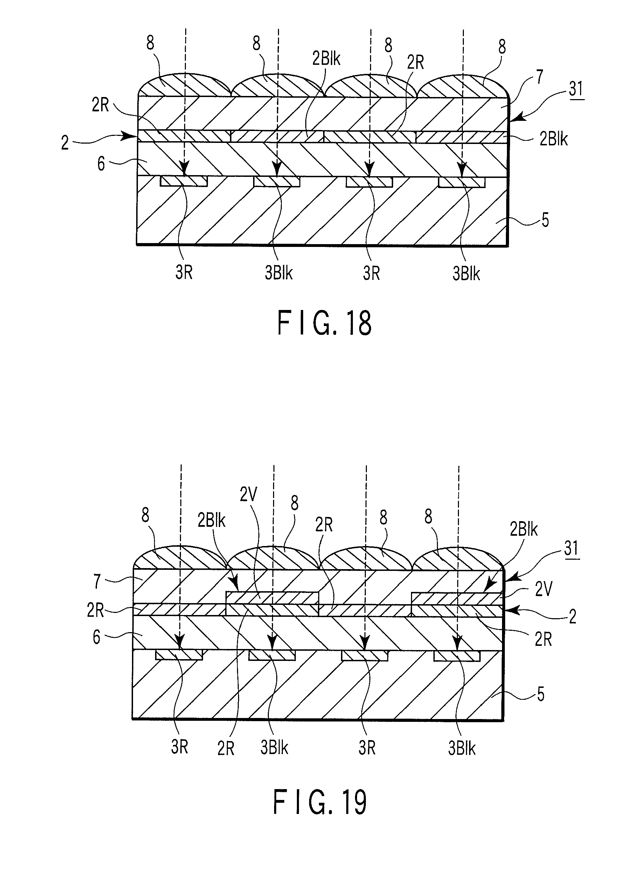

FIG. 17 is a front view showing a state that filters are arrayed in the imaging device 31 f the fifth embodiment. FIG. 18 is a cross-sectional view showing the imaging device 31 of the fifth embodiment. FIG. 18 shows cross section taken along a line III-III' of FG. 17. In FIG. 18, there is shown the case where the light receiving element is CMOS. In this case, the light receiving element may be a CCD, likewise. In the following, other cross-sectional views of the imaging device, the light receiving element may be a CMOS or CCD.

The imaging device 31 of the fifth embodiment includes filter lay 2, light receiving element 3 and operator 4. The filter layer 2 is used for extracting a specified color component of incident light. The light receiving element 3 observes the incident light via the filter layer 2.

The filter layer 2 includes a compensating filter 2Blk in addition to transparent, yellow and red filters 2W, 2Y and 2R. One unit of color separation is formed by combining transparent filter 2W, yellow filter 2Y, red filter 2R and compensating filter 2Blk one by one. These transparent filter 2W, yellow filter 2Y, red filter 2R and compensating filter 2Blk are adjacently arrayed like a mesh. Each filter has a film thickness of 1.4 $\mu$m, and the pixel pitch (of transparent filter 2W, yellow filter 2Y, red filter 2R and compensating filter 2Blk) is 2.6 $\mu$m.

The compensating filter 2Blk has the following characteristics. One is an anti-transmission characteristic (low transmission characteristic) in a visible light wavelength range. Another is a transmission characteristic in a long wavelength range out of visible light. In other words, the compensating filter 2Blk has a characteristic such that the transmittance in the infrared range is higher than that in the visible light wavelength range. Moreover, the compensating filter 2Blk is visibly black.

According to the fifth embodiment, the compensating filter 2Blk is formed by optically overlapping violet (V) and red (R). The following is given as a method of realizing the foregoing optical overlapping. Specifically, a piece of filter is formed using the color material mixing violet color material and red color material. Moreover, a violet filter and a red filter may be stacked.

The light receiving element 3 is arranged on the side opposite to the light incident side of the filter layer 2. The light receiving element 3 further includes a compensating light receiving element 3Blk in addition to incident, yellow and red light receiving elements 3W, 3Y and 3R. These light receiving elements are formed and arrayed on the semiconductor substrate 5.

The compensating light receiving element 3Blk corresponds to the compensating filter 2Blk, and observes the incident light via the compensating filter 2Blk.

The operator 4 includes flue, green and red operating units 4B, 4G and 4R. The operator 4 has a function of calculating the following values. Namely, the operator 4 calculates blue, green, compensated red observed data values Db, Dg and HDr based on observed data values Dw, Dy, Dr and Dblk obtained from incident, yellow, red compensating light receiving elements 3W, 3Y, 3R and 3Blk.

The red operating unit 4R subtracts an observed data value Dblk obtained from the compensating light receiving element 3Blk from an observed data value Dr obtained from the red light receiving element 3R. By doing so, the red operating unit 4R calculates a compensated red observed data value HDr (= Dr - Dblk).

FIG. 18 shows a cross section crossing red and compensating filters 2R, 2Blk red and compensating light receiving elements 3R, 3Blk. Other filters and light receiving elements have the same cross section as shown in FIG. 18.

In FIG. 18, there is shown a compensating filter 2Blk having a single lay formed of a transparent resin mixing red and violet pigments. The compensating filter 2Blk is not limited to the structure shown in FIG. 18, and may be realized by optical overlapping. The optical overlapping is realized using a single-layer colored resin comprising a mixture of different color materials (pigment, dye). Moreover, two different color filters may be stacked, and thereby, the compensating filter is realized. For example, as illustrated in FIG. 19, a violet filter 2V and a red filter 2R are stacked to form the compensating filter 2Blk. Two color materials or more may be used for adjusting color and transmittance.

If two color filters are optically overlapped, the compensating filter 2Blk has a transmittance obtained from the product of the transmittance of each of the overlapped color filters. Therefore, the compensating filter 2Blk is formed using optical overlapping, thereby forming the compensating filter having the following characteristics. One is an anti-transmission characteristic in a visible light wavelength range. Another is a transmission characteristic in the long wavelength side out of the visible light wavelength range.

The following pigment may be used as an organic pigment used for forming the compensating filter 2Blk. It is an organic pigment comprising the organic pigment used for the red filter 2R (e.g., C.I. Pigment Red 177, C.I. Pigment Red 48:1, C.I. Pigment Yellow 139).

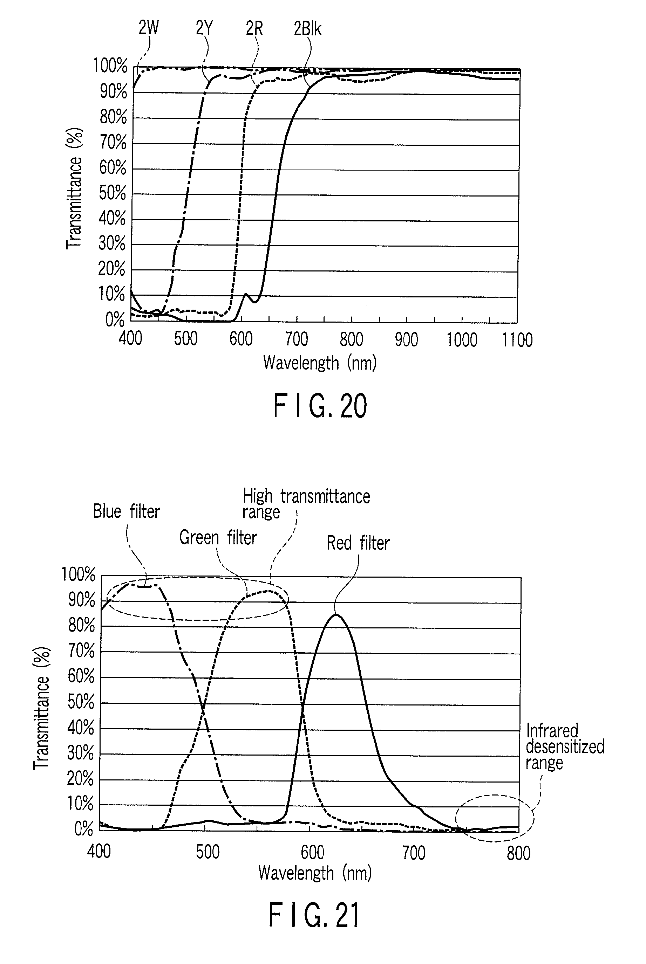

FIG. 20 shows a graph of the spectral transmittance of the compensating filter 2Blk form in the foregoing manner: transparent, yellow and red filters, 2W, 2Y and 2R.

As described above, the imaging device 31 executes a subtraction based on observed data values Dw, Dy, Dr and Dblk of each light receiving element. By doing so, the imaging device 31 obtains blue, green and compensated red, that is, three primary colors Db, Dg and HDr. In other words, the imaging device 31 performs the foregoing operation, and thereby, includes virtual blue, green and red filters.

FIG. 21 is a graph showing the spectral transmittance of virtual blue, green and red filters obtained by the operation performed by the imaging device 31. The spectral transmittance of virtual blue, green and red filters of the imaging device 31 is compared with that of conventional blue, green and red color filters. According to the comparative result, the spectral transmittance of virtual blue, green and red filters of the imaging device 31 has a transmittance higher than conventional blue, green and red color filters. In particular, the virtual blue filter has a transmittance higher than the conventional blue color filter in a blue wavelength range. Therefore, The imaging device 31 of the fifth embodiment has high blue sensitively; as a result, color balance is improved.

Blue, green and compensated red observed data values Db, Dg and HDr obtained from the imaging device are calculated in the following manner. Namely, observed data value in the infrared range is subtracted. Thus, according to the spectral transmittance curve of the virtual blue, green and red filters, there is desensitization of the infrared range (cut). Therefore, the imaging device of the fifth embodiment requires no infrared cut filter; as a result, he imaging device can be formed thinner. Moreover, it is possible to prevent a reduction of red sensitivity resulting from the case where an absorption infrared cut filter is provided.

The same explanation as in the first embodiment applies to "virtual color filter", "noise by dark current", "spectral peaks and troughs" and "ultraviolet and infrared agents".

The following is a supplemental explanation regarding the "spectral characteristic of the compensating filter 2Blk".

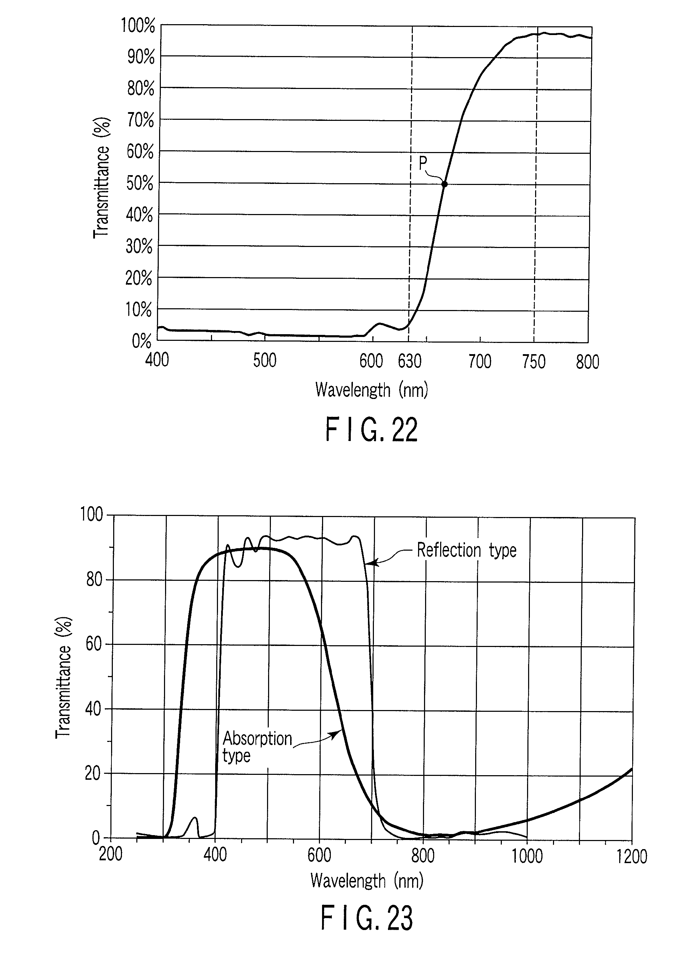

FIG. 22 is a graph showing the spectral characteristic of the compensating filter 2Blk formed in the following manner. The compensating filter 2Blk is formed using acrylic resin dispersion and mixing a violet pigment (e.g., C.I. Pigment Violet 23) and the pigment used for the red filter 2R. The filter has a thickness of 1.4 $\mu$m.

The transmittance of the compensating filter 2Blk is approximately the same (same or approximate) as the red filter of FIG. 20 in a long wavelength side out of the visible light wavelength range.

The observed data value Dblk obtained from the compensating light receiving element 3Blk is subtracted from the observed data value Dr received from the red light receiving element 3R. By doing so, the observed result of the infrared range is deleted from the observed data value Dr received from the red light receiving element 3R. In other words, the compensating filter 2Blk performs a function as an infrared cut filter with respect to the red observed data value.

The compensating filter 2Blk shown in FIG. 22 differs from a general absorption type infrared cut filter sown in FIG. 23. The transmittance (i.e., effective transmittance as an infrared cut filter) is low, in a wavelength range from about 600 nm to 650 nm. Therefore, after the operation (subtraction) is performed, the obtained color rendering is further improved.

According to the fifth embodiment, the difference is less than 5% in the transmittance between the compensating filter 2Blk and the red color filter shown in FIG. 1 in the light wavelength range from 400 nm to 550nm and a range greater than 750 nm. By doing so, the compensated red observed data value HDr is obtained without being affected by the infrared ray and other colors. Therefore, the red color reproducibility is enhanced. Specifically, the transmittance of the compensating filter 2Blk is kept at a low value from 400 nm to 630 nm. Thereafter, the transmittance curve suddenly rises up in a range from 630 nm to 750 nm. When exceeding 750 nm, the transmittance is kept at a high value.

The general absorption type infrared cut filter is in the vicinity of the wavelength 630 nm when the transmittance value becomes half (50%). In general inorganic multi-layer infrared cut filters, the wavelength when the transmittance value becomes half is approximately 700 nm. In the compensating filter 2Blk formed using optical overlapping of violet and red, the wavelength when the transmittance value becomes half is in a range from approximately 650 nm to 660 nm. In the compensating filter 2Blk formed using optical overlapping of cyan and red, the wavelength when the transmittance becomes half is in a range from approximately 740 nm to 750 nm.

Considering the foregoing point, the point P of the compensating filter 2Blk when the transmittance becomes half is within a wavelength range from 630 nm to 750 nm. This is preferable from the viewpoint of improving the red observed data value. Moreover, it is preferable to add an ultraviolet absorbing agent to the transparent filter 2W.

The imaging device 31 of the fifth embodiment calculates the compensated red observed data value HDr. The compensated red observed data value HDr is calculated from the difference between red observed data value Dr and compensating observed data value Dblk. Therefore, the compensating filter 2Blk has the transmittance shown in FIG. 22, and thereby, the compensated red observed data value HDr is not affected by infrared rays or other color light. Moreover, the red sensitivity is high; therefore, an imaging device 31 having excellent color reproducibility is obtained.

According to the fifth embodiment, the compensating filter 2Blk may be formed by optically overlapping two colors; that is, violet and red or cyan and red. The compensating filter 2Blk is formed by combining the foregoing two colors. By doing so, the wavelength position of the compensating filter 2Blk corresponding to 50% can be adjusted according to the ratio of color materials. Color control (adjustment) is further made with respect to the compensated red observed data value HDr.

The following controls may be carried out using other color materials or other color organic pigments. For example, violet, blue and green. One is color control (e.g., gray level control) in the visible light wavelength range of the compensating filter 2Blk. Another is the rise of the transmittance curve of the compensating filter 2Blk in the near-infrared transmission spectra of 700 nm or after 700 nm. Another is control of the wavelength position when the transmittance value becomes half.

Moreover, the imaging device 31 of the fifth embodiment can delete the light observed result of the infrared range, which is not in the human visible range. Therefore, an imaging result close to that of the human sense of vision can be obtained.

The imaging device 31 of the fifth embodiment differs from the general absorption type infrared cut filter having the transmittance characteristic shown in FIG. 23. Namely, the imaging device 31 relaxes light absorption in a wavelength range from 550 nm to 650 nm. Therefore, red color rendering is improved.

In other words, the imaging device 31 of the fifth embodiment includes virtual blue, green and red filters having high transmission. In particular, blue and red observed accuracy are improved as compared with the conventional imaging device.

According to the fifth embodiment, the compensating pixel of the imaging device observes light in the infrared rage. The compensating pixel observed result is subtracted from the red pixel observed result, thereby realizing an infrared absorbing function. With respect to other colors (blue, green), the infrared range is subtracted from the observed result. As a result, it is possible to omit the infrared absorption type infrared cut filter included in the conventional camera module optical system. This serves to make thin the camera.

According to the fifth embodiment, yellow may be used as under color for other colors except transparent portions. In other words, yellow may be included in red and compensating portions except transparent portions. In this case, the yellow filter 2Y is formed of yellow resin, and then, formed at both positions of forming red and compensating filters. Thereafter, the red filter 2R is formed at the position of forming the red filter while the compensating filter 2Blk is formed at the position of forming the compensating filter.

<Sixth embodiment>

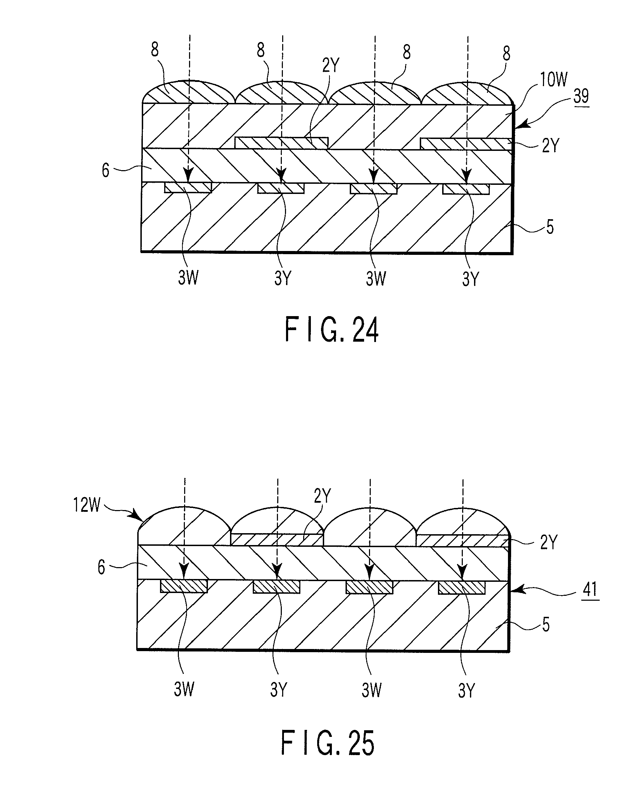

According to the sixth embodiment, an imaging device 39 differs from the imaging device 31 of the fifth embodiment in the following point. The transparent filter 2W and the resin layer 7 are integrated to form a transparent filter 10W. This is equivalent to the imaging device 9 of the second embodiment, which is formed with the compensating filter 2Blk. FIG. 24 shows a cross section of the imaging device 39. FIG. 24 is a cross-sectional view taken along a ling III-III' of FIG. 17.

As described above, in the imaging device 39 of the sixth embodiment, the process of forming the transparent filter 10W and the transparent planarization layer is integrated. Thus, there is no need of independently providing a process of forming the pattern of the transparent filter, that is, in filter formation. Therefore, the manufacture process is simplified. In other words, four color filters are formed via the process of forming three color filters. Namely, one process of forming the filter is removed.

<Seventh embodiment>

According to the seventh embodiment, an imaging device 41 differs from the imaging device of the sixth embodiment in the following point. The transparent filter 2W and the micro lens 8 are integrated to form a transparent filter 12W. This is equivalent to the imaging device 11 of the third embodiment, which is formed with the compensating filter 2Blk. FIG. 25 shows a cross section of the imaging device 41. FIG. 25 is a cross-sectional view taken along a ling III-III' of FIG. 17.

According to the seventh embodiment, the transparent filter 10W and the micro lens 8 are integrally formed, as described above. Therefore, this serves to make thin the imaging device 41.

<Eighth embodiment>

According to the eighth embodiment, a light shield film is provided at areas other than an area at which an incident light is incident.

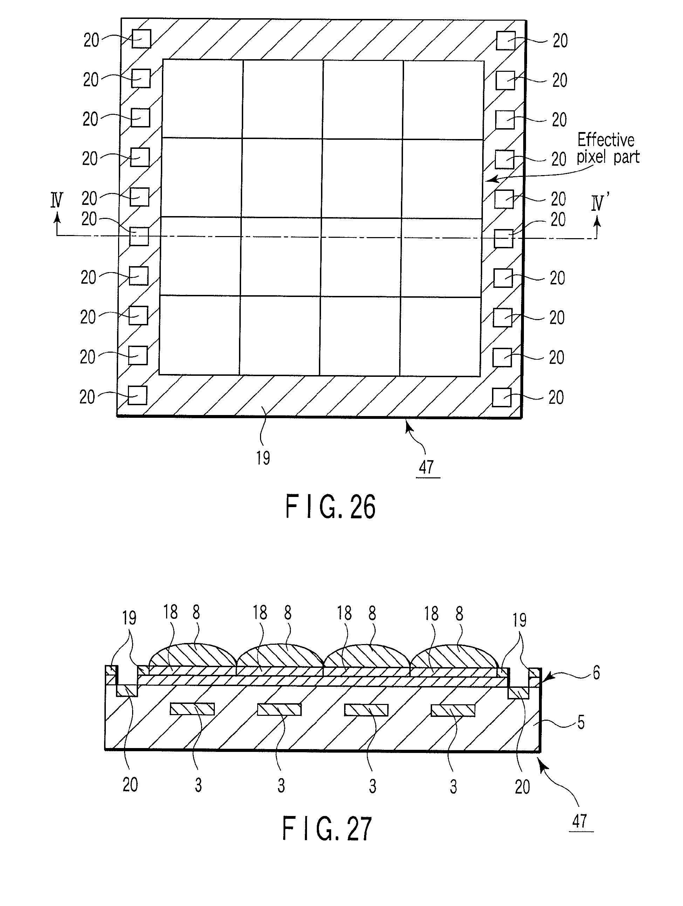

FIG. 26 is a front view showing a first arrangement of a light shield film 19 of an imaging device according to the eighth embodiment. FIG. 27 is a cross-sectional view taken along a ling IV-IV' of FIG. 26.

The compensating filter 2Blk described in the fifth embodiment is used as the light shield film 19. By doing so, it is possible to cut light in a visible light wavelength range, and to reduce stray light on the frame (outer periphery portion) of the imaging device 47.

Incidentally, the light shield film 19 may have a function of cutting infrared rays in addition to the function of cutting visible light. The foregoing light shield film cutting visible light and infrared ray is realized in the following manner. For example, the light shield film is formed to have a film thickness of 0.8 $\mu$m using a resin liquid mixed with a pigment such as carbon black at a solid ratio 40%.

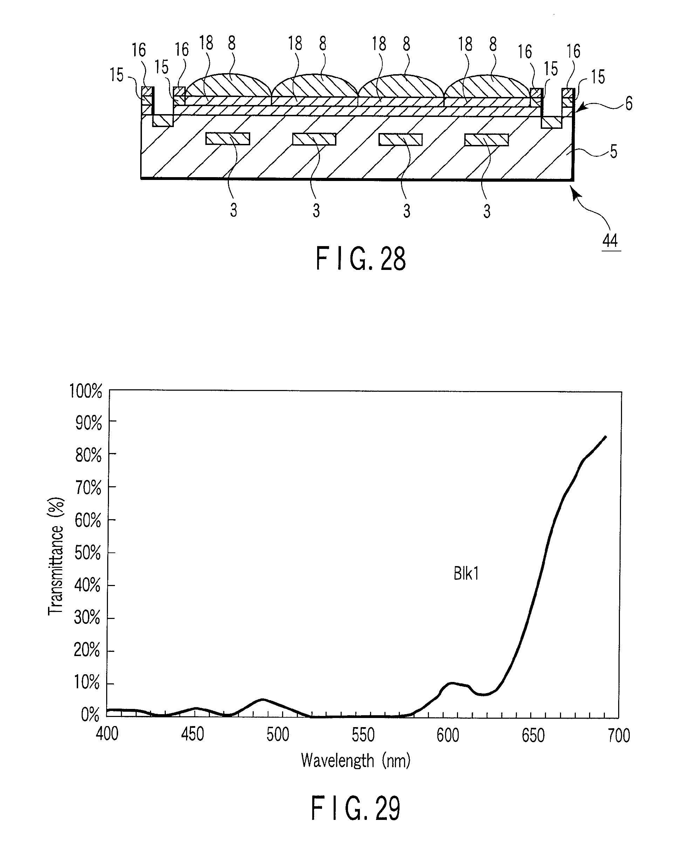

FIG. 28 is a cross-sectional view showing a second arrangement of the light shield film of an imaging device 44 of the eighth embodiment.

The imaging device 44 is characterized in that a light shield film 15 and a film 16 are stacked at the outer periphery of the CMOS light receiving element 3.

For example, the compensating filter 2Blk is usable as the light shield film 15. In other words, the light shield film 15 is formed using the same process as that for forming the compensating filter 2Blk, and thereby, it has the same material quality. The film 16 has at least one of infrared and ultraviolet absorbing functions.

As described above, the imaging devices 44 and 47 of the eighth embodiment are provided with the light shield film. The light shield film is formed at the effective opening periphery of the light receiving element and at part of the semiconductor substrate 5 (e.g., outer periphery of the semiconductor substrate 5). In addition, the light shield film has an anti-transmission characteristic in a visible light wavelength range. Therefore, the light shield film absorbs light incident on areas other than the light receiving element. By doing so, it is possible to prevent unnecessary light such as stray light from being incident on the light receiving element. This serves to reduce noise, and to improve the image quality obtained by the imaging device.

According to the eighth embodiment, the light shield film is arranged at the outer periphery of the effective pixel part. If the light receiving element is a CCD, the light shield film may be formed on the interconnection.

<Ninth embodiment>

The ninth embodiment relates to a detailed example of the compensating filter 2Blk according to the fifth embodiment.

The compensating filter 2Blk of the ninth embodiment has a transmittance of less than 5% with respect to light having a wavelength range 400 nm to 550 nm. According to this spectral characteristic, the wavelength range corresponding to 50% transmittance is in the range from 620 nm to 690 nm. The transmittance is 70% with respect to light having a wavelength 700 nm.

A general absorption type infrared cut filter starts to absorb light from the vicinity of 550 nm. For this reason, according to the ninth embodiment, consideration needs to be given to the increased transmission range of the compensating filter 2Blk used as means for cutting infrared rays. Namely, the rise is 550 nm at the shortest light wavelength. Therefore, the compensating filter 2Blk has a low transmission (transmittance of less than 5%) range from 400 nm to 700 nm.

The compensating filter 2Blk of the ninth embodiment performs an infrared cut function. For this reason, the compensating filter 2Blk has a transmission characteristic in a red and near-infrared range after the wavelength of 550 nm. Here, calculation is made based on human vision. The stimulus value of an RGB color function peaks at 600 nm, and then, drops toward 700 nm. Thus, the compensating filter 2Blk preferably has the following spectral transmittance characteristic (curve shape). Specifically, the transmittance rises from the vicinity of 600 nm, and then, becomes high from the vicinity of 700 nm. Therefore, according to the spectral transmittance characteristic, the wavelength range (half value range) when the transmittance becomes 50% is preferably 620 nm to 690 nm.

The compensating filter 2Blk has an anti-transmission characteristic (low transmission characteristic) in a visible light wavelength range. The compensating filter 2Blk is visibly seen as black.

According to the ninth embodiment, the compensating filter 2Blk is formed of a colored resin composite containing at least each pigment, that is, C.I. Pigment 23 and C.I. Pigment Yellow 139. Moreover, the compensating filter 2Blk is formed of a colored resin composite containing each pigment, that is, C.I. Pigment 23, C.I. Pigment Yellow 139 and C.I. Pigment Red 254.

According to the ninth embodiment, each filter has a film thickness of 1.0 $\mu$m to 1.1 $\mu$m, and the pixel pitch (of transparent, yellow, red and compensating filters 2W, 2Y, 2R ad 2Blk) is 2.6 $\mu$m.

The following three pigments are used as a compensating colored resin composite used for forming the compensating filter 2Blk.

C.I. (Color Index) Pigment Red 245 (abbr. R254)

C.I. Pigment yellow 139 (abbr. Y139)

C.I. pigment Violet 23 (abbr. V23)

Of the three pigments, the R254 may be eliminated. In addition to these three pigments, for color (transmission wavelength) control, a slight amount of another pigment is added.

The weight ratio (%) to the compensating filter colored resin composite of these three pigments (R254, Y139, V23) is as follows.

$$R254 = 0 \text{ to } 15\%$$

$$Y139 = 30 \text{ to } 40\%$$

$$V23 = 55 \text{ to } 65\%$$

The compensating filter colored resin composite contains resin and a solution in addition the foregoing pigments. For example, in order to disperse the pigment Y139 itself, the following is contained with respect to the Y139 having 7 weight parts.

Acrylic resin solution (solid 20%): 40 weight parts

Dispersant: 0.5 weight parts
Cyclohexanone: 23.0 weight parts

The same solution as above is used to disperse V23 and R254.

The following is an explanation about the method of manufacturing the compensating filter 2Blk of the ninth embodiment.

A pigment paste of the forgoing Y139 and V23 is prepared with the weight ratio and weight part described above. The following materials are mixed to form a compensating colored resin composite.

Y139: 14.70 weight parts
V23: 20.60 weight parts
Acrylic resin solution: 14.00 weight parts
Acrylic monomer: 4.15 parts

Initiator: 0.7 weight parts
Sensitizer: 0.4 weight parts
Cyclohexanone: 27.00 weight parts
PGMAC: 10.89 weight parts

Then, the compensating colored resin composite is applied using a spin coater, and thereafter, a dry film is formed having a thickness of 1.1 $\mu$m.

The resultant film (composite) is dried in a state of being placed on a hot plate at 70°C for one minute. Then, the resultant film is exposed using an i-line stepper via a mask forming 5 $\mu$m pixel pattern. In this case, the exposure sensitivity is 1000 mj/cm$^2$.

Using an organic alkali solution, the semiconductor substrate 5 is spun while being developed for 60 seconds using shower coating. The semiconductor substrate 5 is sufficiently rinsed using pure water, and thereafter, is dried by spinning to remove water.

A heat treatment is carried out on the hot plate at 220°C for six minutes to harden a pixel pattern film. By doing so, a compensating filter having a thickness of 1.1 $\mu$m is formed.

A carrier for fixing pigments contained in each filter colored resin composite is composed of acrylic resin, transparent resin, and the precursor or mixture of them.

The transparent resin has a transmittance of 80% or more over the entire wavelength range from 400 to 700 nm, which is a visible range. More preferably, the transparent resin has a transmittance of 90% or more.

The transparent resin includes thermoplastic, thermosetting and activation energy hardening resins. The precursor includes monomer or oligomer generating a transparent resin hardened by activation energy radiation. The transparent resin may be formed of a single resin or a mixture of two or more resins.

FIG. 29 is a graph showing the spectral transmittance characteristic of the compensating filter manufactured in the foregoing manner. Thus, the compensating filter 2Blk of the ninth embodiment has the following spectral transmittance characteristic. Specifically, the transmittance is less than 5% with respect to light of the wavelength range from 400 nm to 550 nm. On the other hand, the transmittance becomes 70% or more with respect to light having a wavelength 700 nm. The wavelength position when the transmittance becomes 50% is within a range from 620 nm to 690 nm.

Therefore, the compensating filter 2Blk of the ninth embodiment differs from the general absorption type infrared cut filter shown in FIG. 23. Namely, the compensating filter 2Blk has low transmittance in the vicinity of a range from 600 nm to 650 nm. Thus, this serves to further improve red color rendering after the operation (subtraction).

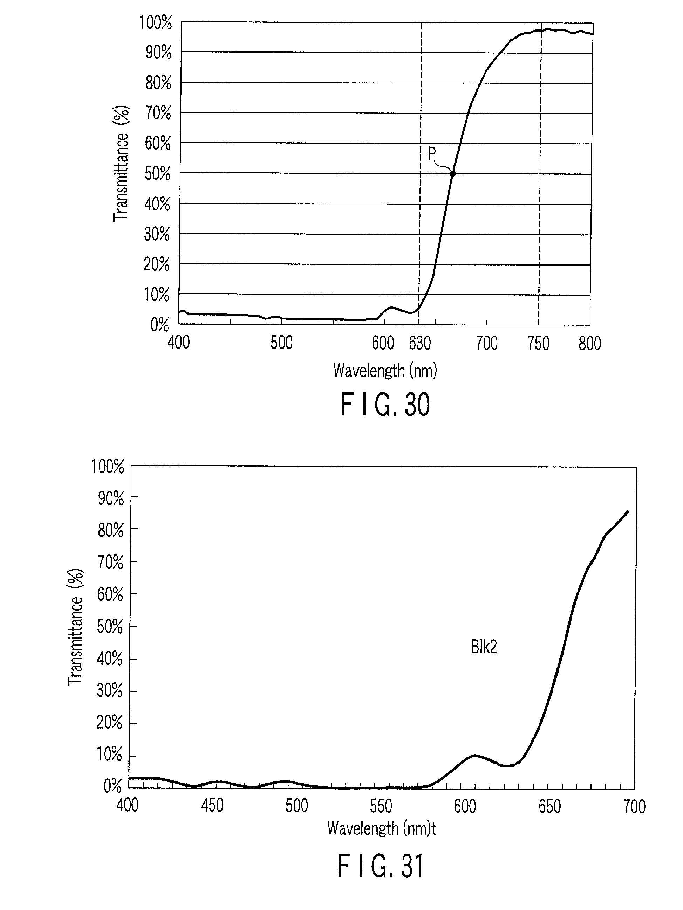

Preferably, the difference is less than 5% between the compensating filter and red color filter (e.g., red filter having transmittance shown in FIG. 1) in the light wavelength range from 400 nm to 550 nm and after 750 nm. Specifically, the transmittance characteristic shown in FIG. 30 is given, and thereby, a compensated red observed data value HDr is obtained without receiving an influence by infrared ray and other colors. Therefore, red reproducibility is enhanced.

The compensating filter 2Blk of the ninth embodiment has the following spectral characteristic. Namely, the transmittance is low in a wavelength range from 400 nm to 550 nm; therefore, visible light is shielded. Thus, it is possible to prevent color noise from being generated in the imaging device provided with the compensating filter 2Blk.

<Tenth embodiment>

The tenth embodiment relates to another example of the compensating filter 2Blk of the fifth embodiment.

A compensating filter 2Blk of the tenth embodiment is formed of pigment paste having the following composition. The compensating filter has a film thickness of 1.1 $\mu$m.

Pigment:

Y139: 11.3 weight parts
R254: 4.23 weight parts
V23: 19.77 weight parts

FIG. 31 shows the spectral characteristic of the compensating filter 2Blk of the fifth embodiment. The pigment composition of a compensating filter colored resin composite is as follows. The pigment R254 is added to the pigment composition (pigment V23 and pigment Y139) of the ninth embodiment.

The spectral characteristic of the compensating filter 2Blk of the fifth embodiment will be described using the graph of FIG. 31. In the graph, the light wavelength (nm) is given on the horizontal axis, and light transmittance of each wavelength is given on the vertical axis. As seen from the graph, the transmittance is less than 5% with respect to the wavelength range from 400 nm to 550 nm. The transmittance becomes 70% or more with respect to light having a wavelength 700 nm. The wavelength position when the transmittance becomes 50% is in a range from 620 nm to 690 nm.

The compensating filter 2Blk of the tenth embodiment has the following spectral characteristic. Namely, the transmittance is low in a wavelength range from 400 nm to 550 nm; therefore, visible light is shielded. Thus, it is possible to prevent a color noise from being generated in the imaging device provided with the compensating filter 2Blk.

<11th embodiment>

The 11th embodiment relates to an imaging device, which includes a transparent filter having an ultraviolet light absorbing function. The imaging device of the 11th embodiment includes an imager 110 and an operator 120.

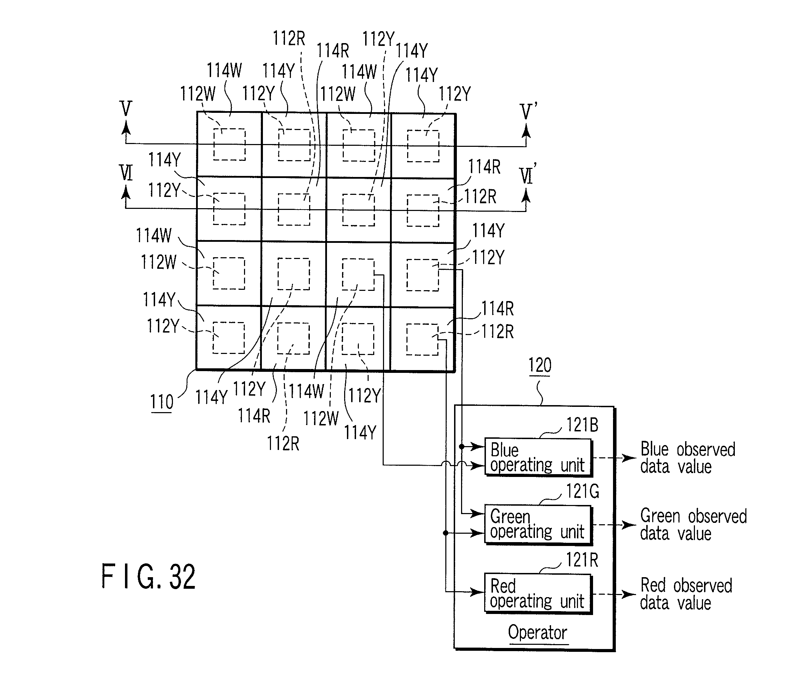

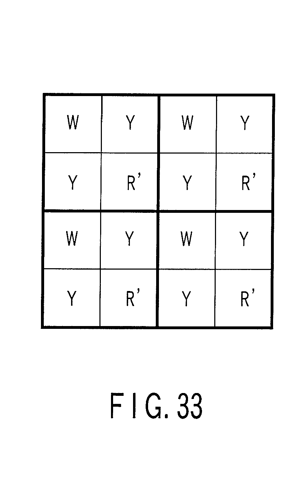

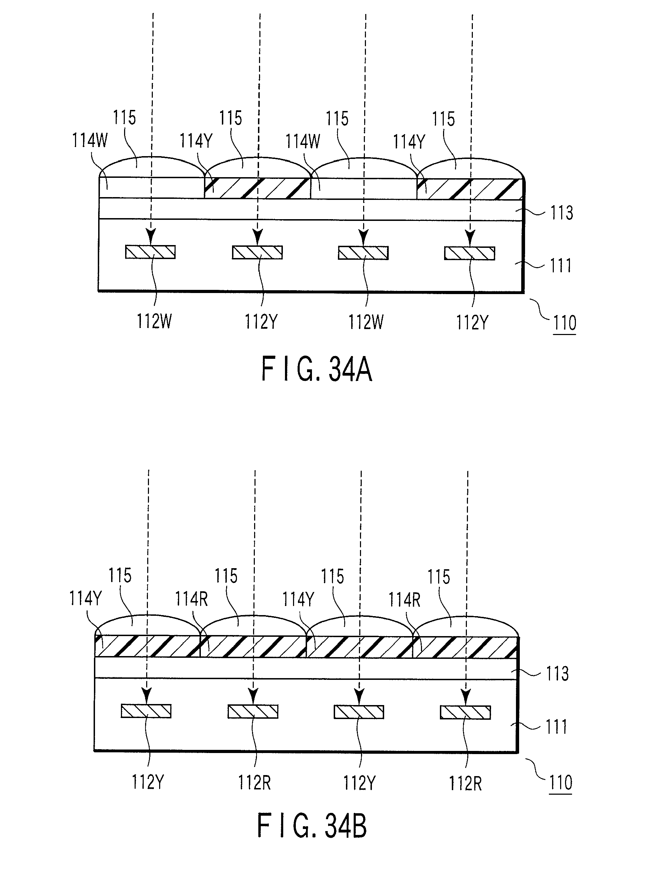

FIG. 32 is a schematic view showing the configuration of the imager 110 and the operator 120 of the imaging device of the 11th embodiment. FIG. 33 is a view to explain the concept of an arrayed state of color filters of the imager 110 when viewing them from the incident light side. FIG. 34A and FIG. 34B are respectively cross-sectional views taken along lines V-V' and VI-VI' of the imager 110.

The imager 110 includes substrate 111, light receiving element 112, planarization layer 113, color filter 114 and micro lens 115.

The substrate 111 is a semiconductor substrate including an interconnection layer capable of making an electric signal exchange. The substrate 11 sends an intensity value (electric signal) of light received by the light receiving element 112 via the interconnection layer.

The light receiving element 112 is formed on the substrate 111, and when receiving light, photo-electrically converts the received light into an electric signal. As described later, according to the 11th embodiment, three color filters 114, that is, transparent, yellow and red filters 114W, 114Y and 114R are formed. For convenience, light receiving elements receiving light via transparent, yellow and red filters 114W, 114Y and 114R are each called white, yellow and red light receiving elements 112W, 112Y and 112R.

The white light receiving element 112W sends an electric signal obtained from the received light to a blue operating unit 121B.

The yellow light receiving element 112Y sends an electric signal obtained from the received light to the blue operating unit 121B and a green operating unit 121G.

The red light receiving element 112R sends an electric signal obtained from the received light to the green and red operating units 121G and 121R.

The planarization layer 113 is stacked on the surface of the light incident side of the substrate 111 formed with light receiving elements 112. The planarization layer 113 planrizes the surface of the color filter 114. Moreover, the planarization layer 113 is formed of an acrylic resin containing coumarin dye at a dye concentration 5% as an ultraviolet light absorbing agent. By doing so, the planarization layer 113 has the following spectral characteristic. Specifically, the planarization layer 113 has a transmittance of 50% with respect to light of a wavelength range from 365 nm to 420 nm. Moreover, the planarization layer 113 has a transmittance of 90% or more with respect to light having a wavelength of 450 nm or more.

The color filters 114 are independently formed on each light receiving element 112 to be adjacent to each other. According to the 11th embodiment, three, that is, transparent, yellow and red filters 114W, 114Y and 114R are formed as the color filter 114. Two pixels are used as the yellow filter 114Y while one pixel is used as each of transparent and red filters 114W and 114R. Thus, one unit of color separation is formed using four pixels in total. When transparent, yellow and red filters 114W, 114Y and 114R are shown as W, Y and R', respectively, a color filter 114 having the arrayed state shown in FIG. 33 is formed.

The transparent filter 114W is a colorless and transparent color filter formed of the same material as the planarization layer 113. Namely, the transparent filter 114W is formed of an acrylic resin containing coumarin dye at a dye concentration of 5%. By doing so, the transparent filter 114W has the following spectral characteristic. Specifically, the transparent filter 114W has a transmittance of 50% with respect to any of a light wavelength range from 365 nm to 420 nm. Moreover, the transparent filter 114W has a transmittance of 90% or more with respect to light having a wavelength of 450 nm or more.

The yellow filter 114Y is a filter for extracting yellow light (synthesizing red and green components) of the light incident on the light receiving element. Specifically, the yellow filer 114Y is a filter transmitting light of a wavelength of the green range or more, which includes red range light and infrared range light. C.I. Pigment Yellow 139 is usable as the color material for the yellow filter 114Y.

The red filter 114R is a filter for extracting red light (synthesizing red and green components) of the light incident on the light receiving element. Specifically, the red filer 114R is a filter transmitting light in a wavelength of the red range or more, which includes infrared range light. C.I. Pigment Red 117, C.I. Pigment 48:1 and C.I. Pigment Yellow 139 is usable as the color material for the red filter 114R.

The micro lens 115 is used for collecting light to the light receiving element 112, and formed on each color filter 114. Incidentally, the micro lens 115 is formed of the same material as the planarization layer 113 and the transparent filter 114W.

The operator 120 includes blue, green and red operating units 121B, 121G and 121R. The operator 120 calculates light three-primary color observed data values based on the intensity value of light receiving from the imager 110. By doing so, color image data is reproducible.

The blue operating unit 121B calculates a blue light observed data value. Specifically, the blue operating unit 121B receives an electric signal from white and yellow light receiving elements 112W and 112Y. The blue operating unit 112B subtracts an intensity value of light received from the yellow light receiving element 112Y from that of light received from the white light receiving element 112W. By doing so, the blue operating unit 121B obtains the blue light observed data value.

The green operating unit 121G calculates a green light observed data value. Specifically, the green operating unit 121G receives an electric signal from yellow and red light receiving elements 112Y and 112R. The blue operating unit 112B subtracts an intensity value of light received from the yellow light receiving element 112Y from that of light received from the red light receiving element 112R. By doing so, the blue operating unit 121B obtains the green light observed data value.

The red operating unit 121R calculates a red light observed data value. Here, the red operating unit 121R takes an intensity value of light received from the red light receiving element 112R as a red light observed value data.

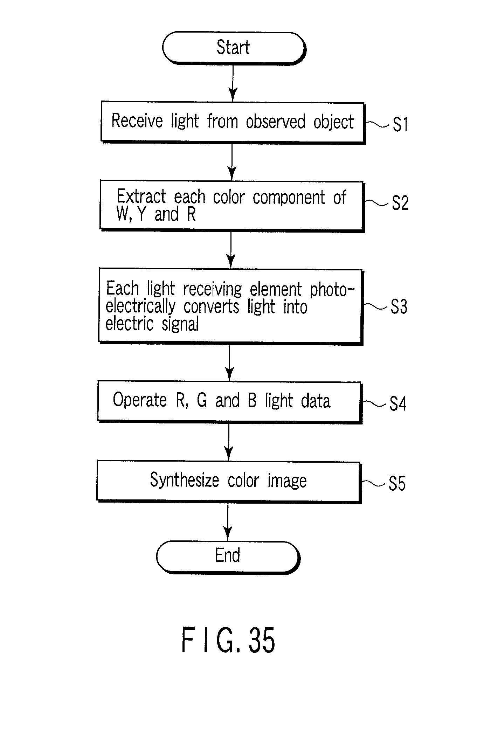

The operation of the imaging device of the 11th embodiment will be hereinafter described with reference to a flowchart of FIG. 35.

When light is radiated from an observed object, part of the light is incident on the imager 110 as an incident light (step S1).

The incident light is collected via the micro lens 115, and thereafter, travels to the light receiving element 112 transmitting through the color filter 114. Here, transparent, yellow and red filters 114W, 114Y and 114R are formed as the color filter. Therefore, white, yellow and red light receiving elements 112W, 112Y and 112R extracts incident light, yellow light and red light, and removes ultraviolet light (step S2).

Light entering each light receiving element 112 is converted into an electric signal, and thereafter, sent to the operator 120 (step S3). In this case, light transmitting through each of transparent, yellow and red filters 112W, 112Y and 112R is sent to the operator 120.

Thereafter, operating units 121 of the operator 120 calculate red, green and blue light observed data values, respectively (step S4). In this case, intensity values of incident, yellow and red lights obtained by light receiving elements are set as Dw, Dy and Dr. Moreover, three primary colors, that is, red, green blue observed data values are set as Db, dg and dr. The foregoing setting is made, and thereby, the following equations (3) and (4) are satisfied.

$$Db = Dw - Dy \quad \ldots (3)$$

$$Dg = Dy - Dr \quad \ldots (4)$$

Three primary color light data in each pixel obtained in this manner are synthesized, and thereby, color image data of the observed object is created (step S5).

As described above, the imager 110 of the 11th embodiment includes planarization layer 113 and transparent filter 114 having the following spectral characteristic. Namely, the transmittance is 50% with respect to light having a wavelength range from 365 nm to 420 nm. Moreover, the transmittance is 90% or more with respect to light having a wavelength of 450 nm or more. Therefore, the imaging device 20 can obtain light observed data values corrected for effects due to ultraviolet rays. By doing so, a blue light observed data value close to the human sense of vision is obtained. Thus, it is possible to provide an imager 110 that is excellent in color balance and color reproducibility.

Moreover, the imager 110 is configured to have micro-fabricated pixels. Namely, the micro lens 115 for collecting light to each light receiving element 112 is formed on each color filter 114. By doing so, a small-sized imaging device is provided.

The color filter 114 of the imager 110 includes yellow and red filters 114Y and 114R. Thus, a color image from the observed object is reproduced from the intensity value of light via transparent, yellow and red filters 114W, 14Y and 114R. This serves to reduce a noise as compared with an imaging device using the conventional compensating color filter. Therefore, vivid colors close to primary colors, are reproduced.

As seen from the foregoing equation (3), the blue light data is calculated based on the intensity value of the incident light via the transparent filter 114W. Depending on the kind of the imaging device, the light receiving element 112 has various sensitivities in the ultraviolet range. For this reason, when the light receiving element 112 receives incident light that includes ultraviolet rays, the following problems arise. In brief, it is difficult to consistently reproduce the blue light observed data value due to the many kinds of imaging devices. Moreover, alignment with the human sense of vision becomes insufficient. In order to solve the foregoing problems, the transparent filter 114W of the 11th embodiment is used. By doing so, it is possible to obtain a light observed data value that is corrected for effects due to ultraviolet rays. Therefore, reproducibility of the blue light observed data value and color rendering are improved regardless of the kind of imaging device.

Moreover, the planarization layer 113 absorbs an influence of halation from the substrate in pattern exposure when the color filter is formed using a photolithography process. This serves to prevent the pixels of the color filter from being thickened. Namely, an ultraviolet absorbing agent is added to the planarization layer 113, and thereby, it is possible to prevent halation of the exposure light from the substrate 111. Thus, a filter having a good shape is formed.

The imaging device of the 11th embodiment performs the following operation to obtain the blue light observed data value. The blue light observed data value is obtained based on the electric signal obtained via the transparent filter 114W and the same is obtained via the yellow filter 114Y. The transparent filter 114W has low transmittance in a short-wavelength range and has the rise part of the transmittance. Moreover, the transparent filter 114W has high transmittance in a long-wavelength range. Thus, the transparent filter 114W has a substantially S-shaped spectral transmittance curve. In this case, the transparent filter 114W has the spectral characteristic curve showing the following features. Namely, light transmittance becomes 50% in a light wavelength range from 365 to 420 nm. (More preferably, the light transmittance becomes 50% in a light wavelength range from 390 to 420 nm.) By doing so, the blue light observed data value obtained from the operation has the following advantages. Specifically, color balance and reproducibility are excellent, and a vivid blue color can be seen with the human eye.

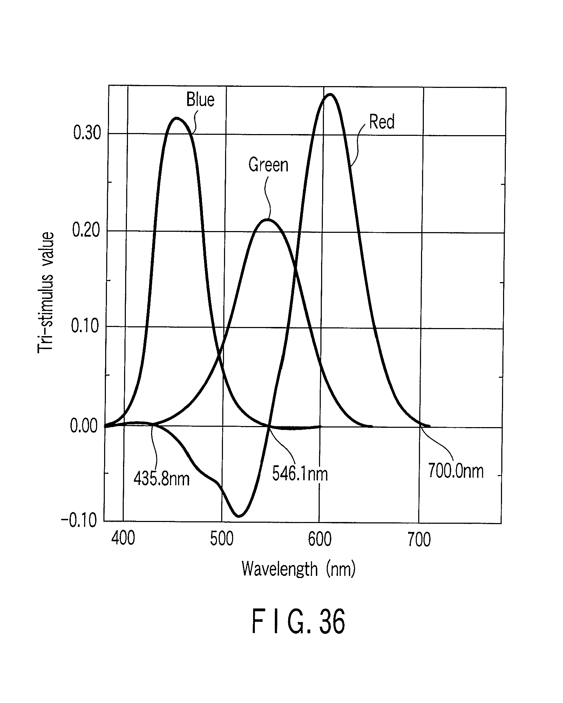

A supplemental explanation about the foregoing point is made. FIG. 36 is a graph showing the human eye stimulation value of light, which changes according to wavelength of R (red), G (green) and B (blue) colors. As seen from FIG. 36, a B (blue) human eye spectral stimulus value has a peak (maximum value) in the vicinity of a light wavelength from 445 to 450 nm. The half value (50% stimulus value of the maximum value) of the maximum stimulus value exists in the vicinity of a light wavelength from 420 nm to 425 nm on a short-wavelength side from light wavelength becoming the maximum stimulus value. Thus, the transparent filter of this embodiment is used, and thereby, a vivid blue color can be seen by the human eye. As shown in FIG. 1, the peak value of light transmittance of the conventional blue filter exists in a light wavelength range of about 450 nm. The light transmittance in the light wavelength range of about 540 nm is about 80% (transmittance is measured using a glass substrate as a reference).

The transparent filter 114W has a light transmittance of 90% or more in the wavelength of 450 nm. Therefore, the imaging device of the 11th embodiment improves blue sensitivity.

According to the 11th embodiment, the transparent filter 114W is formed of an acrylic resin containing coumarin dye at a dye concentration of 5% as an ultraviolet light absorbing agent. Resins other than acrylic resin are usable. For example, a resin containing one or more of epoxy, polyimide, and phenol novolac resins may be used.

According to the 11th embodiment, the transparent filter 114W is formed of an acrylic resin containing coumarin dye at a dye concentration of 5% as an ultraviolet light absorbing agent. For example, benzotriazole, benzophenone, salicylic acid, and hinder domine compounds may be used as the ultraviolet absorbing agent. Moreover, the following dyes are usable. Specifically, azoic dye, azoic metal complex salt dye, anthraquinone dye, indigoid dye, thio-indigoid dye, phthalocyanine dye, diphenyl-methane dye, tri-phenyl methane dye, xanthene dye, thiazine dye, kaothine dye, cyanine dye, nitro dye, quinoline dye, naphthoquinone dye, and oxiasin dye. Moreover, an optical polymeric monomer, such as bi-functional monomers or tri-functional monomer or multi-functional monomer is usable. As the bi-functional monomer, 1.6-hexadior acrylate, ethylene glycol di-acrylate, neo-penthyl glycol di-acrylate, and tri-ethylene glycol di-acrylate are given. As the tri-functional monomer, tri-methylolu prohasen tri-acrylate, pentaerythritol tri-acrylate, tris (2-hydroxymethyl) isocyanate are given. As the muli-functional monomer, ditri-methylolu propantetra acrylate, di-pentaerythritol penta and hexacrylate are given. As others, optical polymer initiators such as the following derivatives are usable. Specifically, halo-methylation triazine derivative, halo-methylation oxadiazol derivative, imidazol derivative, benzoinalkyl ether group, anthraquinone derivative, benzanthron derivative, benzophenone derivative, acetophenone derivative, thioxisanton derivative, benzoic acid ester derivative, acridine derivative, phenazin derivative and titanium derivative. A functional group having ultraviolet light absorption is pendent to a resin polymer or monomer as a hardener, or polymerized to have a group incorporated into a polymer. For example, a quinone group and anthracene may be introduced into a polymer, or a monomer having an ultraviolet light absorption group may be added.

The foregoing ultraviolet light absorbing agent is properly used, and thereby, the spectral characteristic of the transparent filter 114W is changed. The half value on the short-wavelength side (light wavelength value when transmittance becomes 5% in the spectral characteristic curve) is set. By doing so, it is possible to select the color characteristic (color and organic pigment close to actual visual sensitivity).

(Peeling of pixels)

Peeling of pixels will be hereinafter described.

In recent years, high-definition CMOS and CCD having six million pixels or more are required. In the foregoing high-definition CMOS and CCD, it is frequently necessary to use a color filter having a pixel size of 2 $\mu$m $\times$ 2 $\mu$m or less.

However, there is a problem that such color filter (pixel) is easy to peel off, resulting from the scale-down of the pixel size. In particular, the foregoing problem becomes very apparent in a color filter using a blue organic pigment. This is because the transmittance of the blue color resist is low (less than 1%) in a pattern exposure light wavelength of 365 nm. For this reason, the exposure light does not travel to the lower portion of the blue color resist. In other words, if the blue color filter is patterned and exposed using a photolithography process, the portion to be inherently hardened does not have the required hardness. On the other hand, in the red and green color resists, the pattern exposure light of the wavelength 365 nm is sufficiently transmitted through the resist (transmittance range from about 5 to 10%). As a result, the lower portion of the color resist is sufficiently hardened. Thus, red and green color filters are relatively hard to peel off.

Conversely, in order to fully harden the color resist and to prevent the color filter from peeling off, the following is required. Specifically, the transmittance of the blue color resist is made high with respect to the pattern exposure light of the wavelength of 365 nm. However, if the transmittance is made high in the wavelength range of the pattern exposure light of the blue color resist, the following problem arises. Namely, the transmittance becomes high in red and green light wavelength ranges where the transmittance should be made as low as the blue color resist. As a result, color separation as blue color resist is reduced. For this reason, the imaging device using the conventional blue, green and red filters has the following problem. That is, light with respect to several colors is transmitted; for this reason, color separation becomes worse.

In order to solve the foregoing problem, in the imaging device of the 11th embodiment, white and yellow filters are hardened in the pattern exposure light having the wavelength 356 nm. This serves to prevent a phenomenon in which pixels peel off, and to calculate the blue observed data value. Therefore, an imaging device having an improved color separation is provided.

Moreover, the following problem arises. Namely, the micro-fabricated color filter receives an influence of halation from the substrate in pattern exposure using the photolithography process. As a result, the pixels become thicker. Thus, color un-evenness and mixing occur.

In order to solve the foregoing problem, the imaging device of the 11th embodiment has the planarization layer 113 to which the ultraviolet absorbing agent is added. Therefore, the planarization layer 113 absorbs halation of exposure light from the substrate in the pattern exposure. As a result, it is possible to prevent the pixels of the color filter from becoming thick, and to form a filter having a good shape. Thus, an imaging device having an improved color separation is provided.

<12th embodiment>

The 12th embodiment relates to a method of manufacturing the imager 110 according to the 11th embodiment.

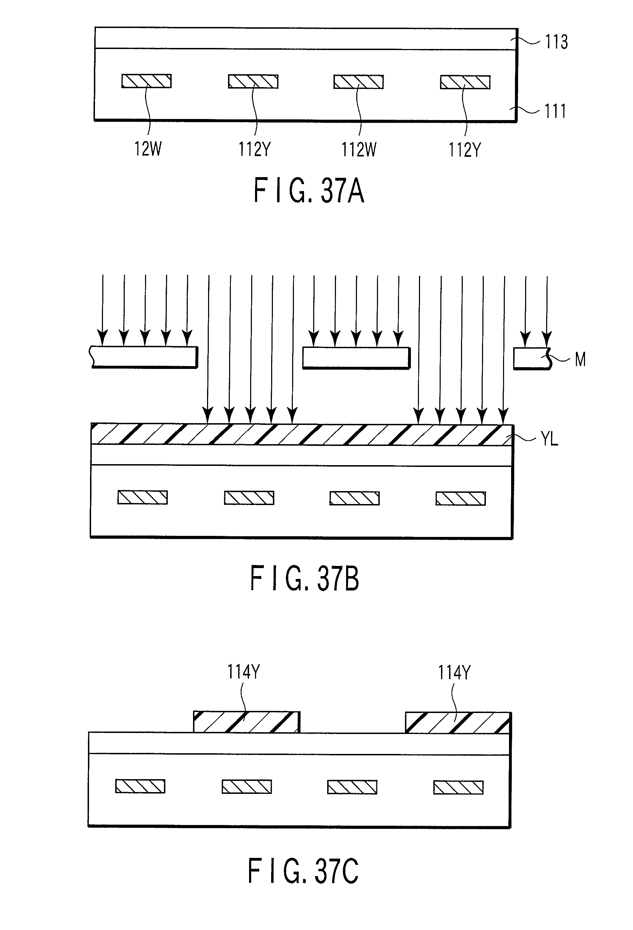

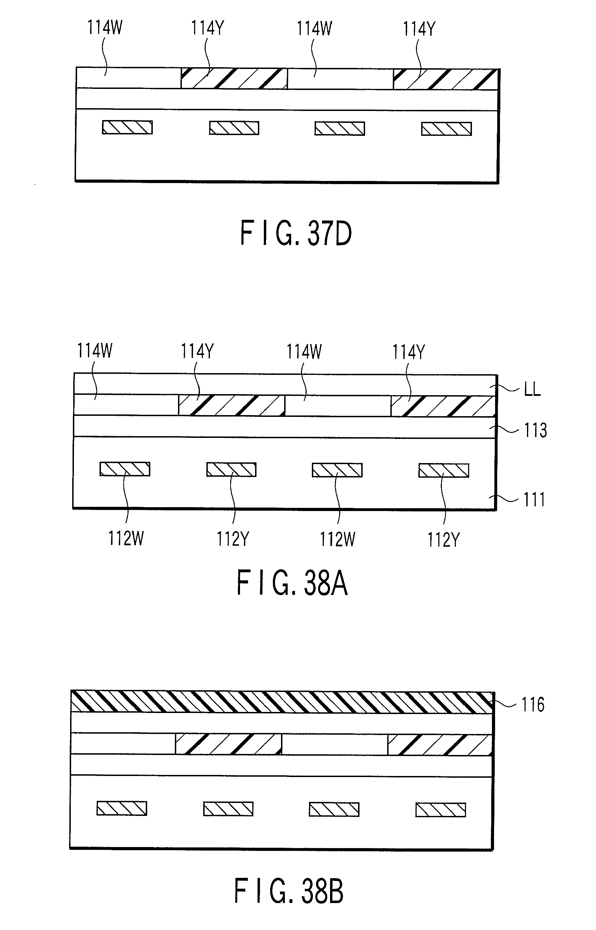

The method of manufacturing the imager 110 according to the 12th embodiment will be hereinafter described with reference to FIG. 37A to FIG. 37D and FIG. 38A to FIG. 38E.

A planarization layer 113 is formed on a substrate 111 formed with light receiving elements (112W, 112Y in FIG. 37) (FIG. 37A). The planarization layer 113 is formed of an acrylic resin containing coumarin dye at a dye concentration of 5%.

A yellow resin layer YL is formed on the planarization layer 113. The yellow resin layer YL is a photosensitive resin layer formed in the following manner. For example, C.I. Pigment Yellow 139, organic solution such as cyclohexanone and PGMEA, polymer vanish, monomer and initiator are added to a photosensitive acrylic resin.

Then, pattern exposure is carried out using a mask M (FIG. 37B). In this case, the exposed portions start a chemical reaction, and become alkali in-solution.

Portions to which light is radiated are removed using a developer, such as an alkali solution. By doing so, the Yellow filer 114Y is formed (FIG. 37C). In other words, the yellow filter 114Y is formed via the photolithography process.

Although no illustration is given, the red filter 114R is formed in the same manner as above.

After yellow and red filters 114Y and 114R are formed, a transparent filter 114W is formed (FIG. 37D).

Then, a lens layer LL is formed using a transparent resin. Specifically, the lens layer LL is formed of the same material as that of the planarization layer 113 (FIG. 38A).

A phenol resin layer is formed on the lens layer LL (FIG. 38B). The phenol resin layer 116 is formed for controlling the etching rate in dry etching described later to obtain a micro lens of the desired shape. Thus, preferably, the etching rate of the phenol resin layer 116 is slower than that of a lens material 117M. In this case, the phenol resin layer 116 performs a function of controlling thermal reflow when forming the lens material 117M described later using the thermal reflow.

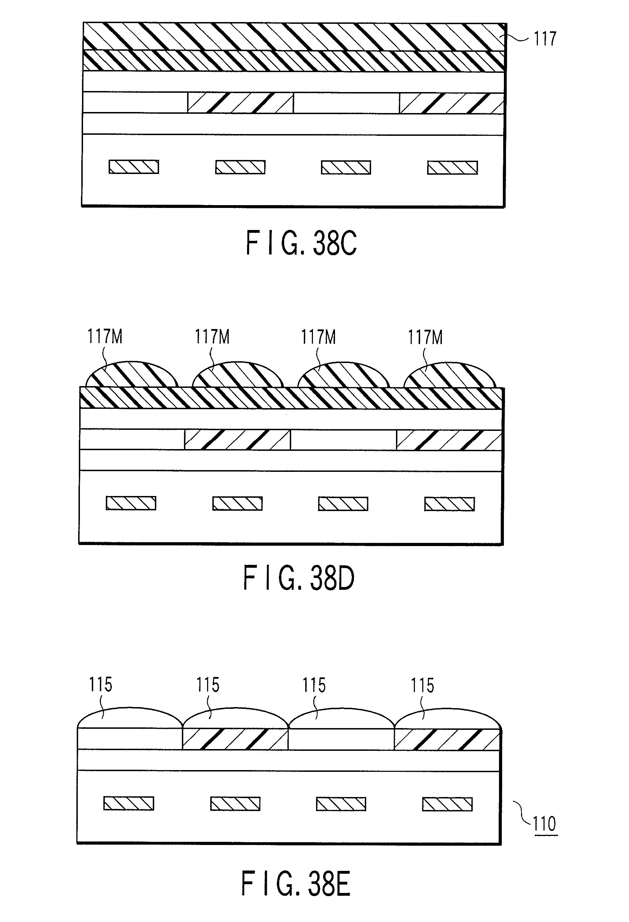

A photosensitive resin layer 117 is further formed on the phenol resin layer 116 (FIG. 38C). The photosensitive resin layer 117 is formed of an acrylic resin having alkali soluble, photosensitive and thermal reflow.

Then, the photosensitive resin layer 117 is formed into a rectangular pattern using the photolithography process. Thereafter, the photosensitive resin layer 117 is reflowed to make it round, using a heat treatment. By doing so, the lens material 117M is formed (FIG. 38D).

Dry etching is carried out using the lens material 117M as a mask. By doing so, the shape of the lens material 117 is transferred to the lens layer LL via the phenol resin layer 116, and thus, a micro lens 115 is formed (FIG. 38E).

According to the foregoing method, the imager 110 is manufactured.

In the imager 110, the transparent filter 114W and the micro lens 115 each have the same material quality, and are integrally formed. This serves to simplify the manufacture process.

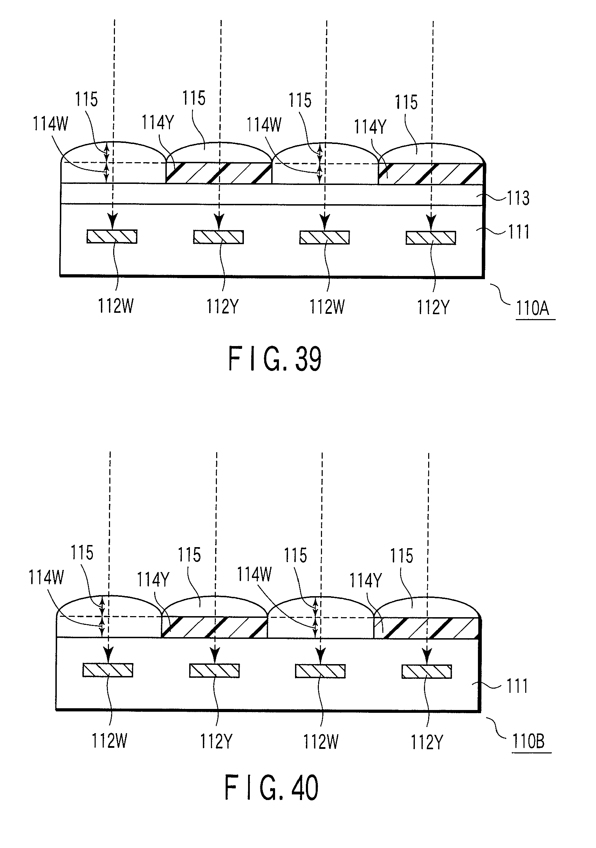

Specifically, according to the 12th embodiment, the transparent filter 114W and the lens layer LL for forming the micro lens 115 are independently formed. The transparent filter 114W and the micro lens 115 have the same material quality; therefore, the processes of FIG. 37D and FIG. 38A are simultaneously carried out. In other words, after the process of FIG. 37D, a portion for forming the transparent filter 114W is filled. Then, the lens layer LL containing an ultraviolet light absorbing agent is applied to cover the red and yellow filters 114R and 114Y by one-time coating. Thereafter, the process of forming the micro lens 115 is carried out. By doing so, it is possible to manufacture an imager 110A shown in FIG. 39 having a structure in which the transparent filter 14W and the micro lens 115 are integrally formed. This serves to simplify the manufacture process.

As depicted in FIG. 40, an imager 110B is formed with no planarization layer 113, and thereby, the manufacture process is further simplified.

<13th embodiment>

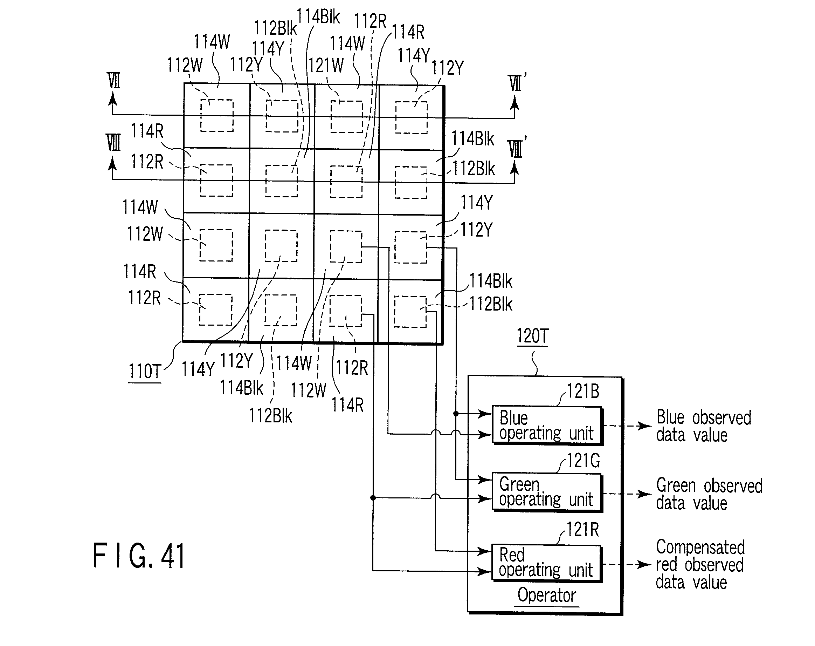

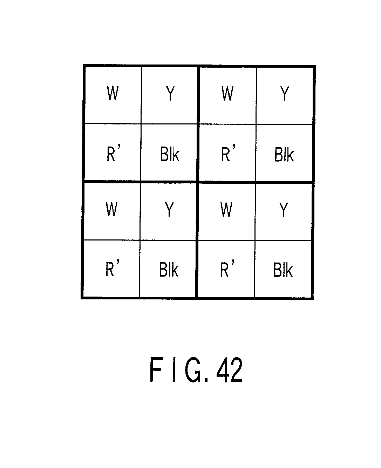

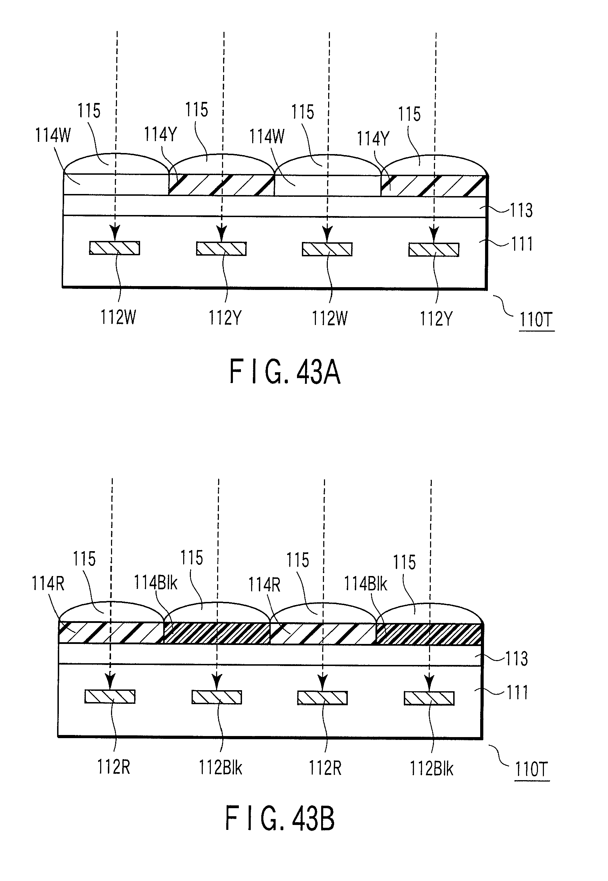

FIG. 41 is a schematic view showing the configuration of an imaging device according to 13th embodiment of the present invention. FIG. 42 is a view to explain the concept of a state in which color filters 114 in an imager 110T are arrayed when viewing them from the incident light side. FIG. 43A and FIG. 43B are cross-sectional views taken along lines VII-VII' and VIII-VIII' of the imager 110T of FIG. 41, respectively.

The imager 110T has a structure in which the imager 110 of the 11th embodiment further includes a compensating filter 114Blk. The compensating filter 114Blk does not transmit visible light, and transmits light in an infrared range to extract an infrared ray. For convenience, a light receiving element receiving light via the compensating filter 114Blk is called a black light receiving element 112Blk.

The black light receiving element 112Blk sends an electric signal obtained from the received light to a red operating unit 121R.

A pigment mixing C.I. Pigment Red 254, C.I. Pigment Yellow 139 and C.I. Pigment Violet 23 is usable as the color material of the compensating filter 114Blk.

A set of transparent, yellow, red and compensating filters 114W, 114Y, 114R and 114Blk corresponds to one pixel. When these transparent, yellow, red and compensating filters 114W, 114Y, 114R and 114Blk are expressed as W, Y, R' and Blk, a color filter 114 having an arrayed state shown in FIG. 42 is formed.

The red operating unit 121R receives electric signals from red and black light receiving elements 112R and 112Blk. By doing so, a compensated red light observed data value is calculated based on each intensity value of light received via red and compensating filters 114R and 114Blk.

With the foregoing configuration, the intensity values of lights obtained from incident, yellow and red light receiving elements 112W, 112Y and 112R are each set as Dw, Dy, Dr and Dblk. Further, blue, green and compensated red light observed data values are set as Db, dg and HDr. By doing so, the following equations (5) to (7) are established.

$$Db = Dw - Dy \qquad \dots (5)$$

$$Dg = Dy - Dr \qquad \dots (6)$$

$$HDr = Dr - Dblk \qquad \dots (7)$$

The imager 110T of the 13th embodiment includes the compensating filter 114Blk; therefore, a red observed data value removing an influence of infrared ray is obtained. By doing so, light colors close to those of human visual sensitivity are obtained. Thus, it is possible to provide an imaging device that is excellent in color balance and color reproducibility.

The imaging device of the present invention formed with the compensating filter 114Blk has an effect of removing an influence of ultraviolet rays. In addition to the effect, it is possible to produce a small-sized imaging device having high sensitivity and excellent color reproducibility as compared with the imaging device including an infrared cut filter.

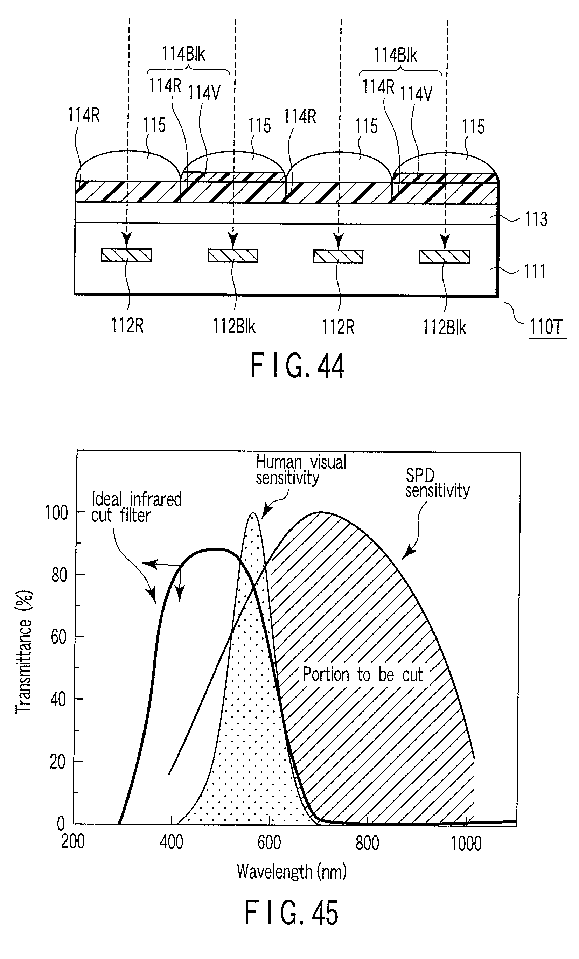

According to the 13th embodiment, as shown in FIG. 44, the compensating filter 114Blk may be formed by optically overlapping the violet color filter 114V and red filter 114R. The violet filter 114V is formed of C.I. Pigment violet 23, for example.

(Compensating filter)

The following is a supplementary explanation about the compensating filter 114Blk.

Solid-state imaging devices, such as a CCD and CMOS, have high sensitivity in a range outside that of the range of human vision (e.g., 400 nm to 700 nm). A wavelength range on the long-wavelength side from the visual light wavelength range is hereinafter called "infrared range". For example, a high sensitivity exists in a wavelength range from 700 nm to 1100 nm. A normal organic color filter has no function of cutting light (infrared ray) in the infrared range. For this reason, light outside the range of human vision (e.g., long wavelength side from 700 nm) is incident on the light receiving element. Thus, there may be a difference between the color of the observed object obtained by the imaging device and the color that a human actually sees.

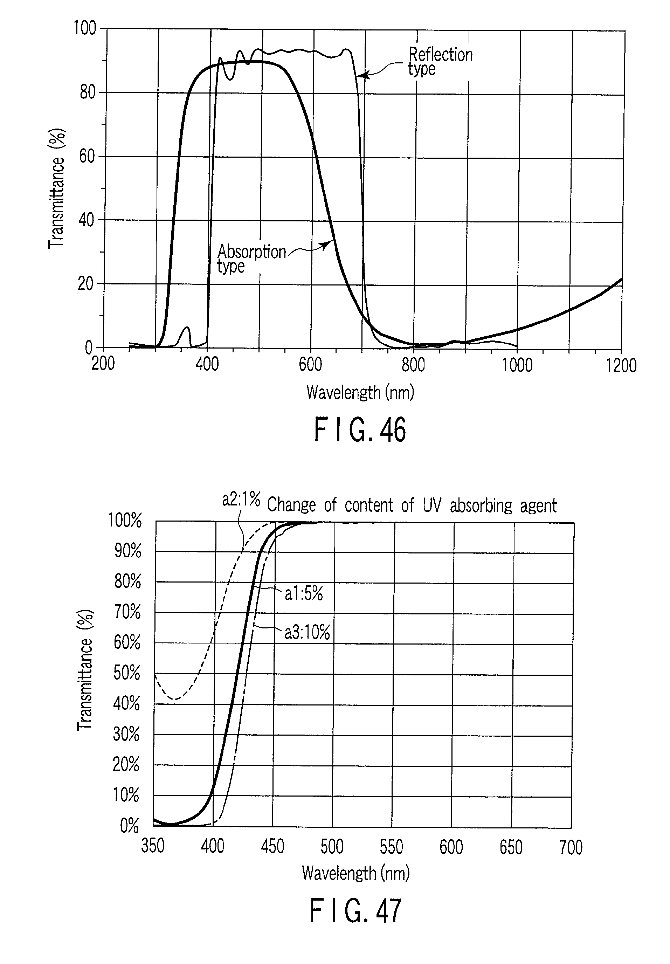

FIG. 45 shows the relationship between the wavelength and transmittance as regards the sensitivity of human vision, sensitivity of a light receiving element (SPD sensitivity) and ideal infrared cut filter. In FIG. 45, if the infrared cut filter cuts the incident light belong to the slanted wavelength range, a color close to that perceived by human vision is reproducible. The infrared cut filter has two kinds, that is, a reflection type and an absorption type. FIG. 46 shows the relationship between wavelength and transmittance in reflection type and absorption type infrared cut filters.

However, if the infrared ray is cut using an infrared cut filter, the following problem arises.

First, it is difficult to reduce the size of the imaging device. For example, Jpn. Pat. Appln. KOKAI Publications No. 2000-19322 and 63-73204 have proposed a technique of incorporating an infrared cut filter into an optical system of the imaging device. However, according to the foregoing technique, the infrared cut filter is inserted to cover light receiving elements such as a CMOS or CCD. Thus, the infrared cut filter is thick; for this reason, it is difficult to reduce the size of an imaging device of the optical system. For example the absorption type infrared cut filter has a thickness of about 1 to 3 mm.

Moreover, there is a problem that it is difficult to reduce the manufacturing cost. Specifically, if the color filter is used as a camera component, the process of incorporating the infrared cut filter into a lens system is required. Thus, it is difficult to reduce the manufacturing cost.

The foregoing problem is solved in the following manner. Namely, an influence of an infrared ray is removed through use of a compensating filter.

There exists an imaging device that includes three primary color filters (R, G, B) or complementary color filters (C, M, Y). The foregoing imaging device has a problem that sensitivity is reduced if the infrared cut filter is used. This is because an infrared ray is cut via all light receiving elements in the imaging device using the infrared cut filter. Thus, the infrared cut filter absorbs light of a visual wavelength range from 550 nm to 700 nm. As a result, there is a problem that sensitivity is reduced in an imaging that has green and red color filters.

The forgoing problem is solved in the following manner. Namely, transparent, yellow and red color filters 114W, 114Y and 114R are used, and further, a compensating filter 114Blk is used. Specifically, blue, green red light observed data values are obtained and reproduced based on the intensity values of light obtained via transparent, yellow, red and compensating filters 114W, 114Y, 114R and 114Blk. Therefore, the three primary colors are reproducible without reducing the sensitivity. The compensating filter 114Blk is further used, so that an influence of infrared rays is only removed from red light observed data value.

(Example 1)

The method of manufacturing the solid-state imaging device according to an example 1 of the 13th embodiment will be hereinafter described.

First, a semiconductor substrate 111 is formed with light receiving elements 112, light shield film and passivation. A thermosetting acrylic resin containing coumarin dye at a dye concentration 5% is applied using spin coating. Thereafter, a heat treatment is carried out to harden the resin and to form a film. By doing so, a planarization layer 113 formed of transparent resin is formed. In FIG. 47, a1 shows the spectral characteristic of the planarization layer 113 after being hardened. For comparison, a2 and a3 show each spectral characteristic when containing coumarin dye at dye concentrations of 1% and 10%.

Yellow, red and compensating filters 114Y, 114R and 114Blk are individually formed via three-time photolithography processes. The pixel pitch is 2.5 μm. The arrayed state of each filter is the same as shown in FIG. 42.

The C.I. Pigment Yellow 139 is used as the color material of a color resist (yellow resin layer YL) for forming the yellow filter 114Y. Further, according to the composition, cyclohexanone, organic solvent such as PGMEA, polymer vanish, monomer and initiator are added to a photosensitive acrylic resin.

C.I. Pigment Red 177, C.I. Pigment Red 48:1 and C.I. Pigment Yellow 139 are used as the color material of a color resist for forming the red filter 114R. The remaining composition is the same as that of the yellow filter 114Y.

C.I. Pigment Red 254, C.I. Pigment Yellow 139 and C.I. Pigment Violet 23 are used as the color material of a color resist for forming the compensating filter 114Blk. The remaining composition is the same as that of the yellow filter 114Y.

Then, the same acrylic resin solution as the planarization layer 113 I applied on the color filter 114 to have a film thickness of 0.8 μm. Thereafter, the resultant is heated at 200°C for six minutes, and then, hardened to form a film, and thereby, a lens layer LL is formed. A phenol resin is applied to a film thickness of 1.0 μm to form a phenol resin layer 116. The phenol resin layer 116 has an etching control function and a thermal reflow control function. An acrylic resin (lens shape material) having alkali soluble, photosensitive and thermal reflow is further applied to form a photosensitive resin layer 117.

The photosensitive resin layer 117 (lens shape material) is formed into a rectangular pattern via the photolithography process using a developer. Then, the resin layer 117 is reflowed via a heat treatment of 200°C. By doing so, a rounded semi-spherical lens material 7 M is formed. If reflow is correctly conducted, a height of 0.45 μm, one side of 0.15 μm, and gap of 0.35 μm between lens shape materials are given, thereby forming a smooth semi-spherical lens material 117M.

Finally, etching is carried out in a dry etching system using a mixed gas of chlorofluorocarbon gases C3F8 ad C4F8 and using the lens shape material 117M as a mask. By doing so, no gap between lenses is substantially given, and then, a micro lens 115 having a narrow gap between lenses is formed.

The etching rate of the acrylic resin used in the 13th embodiment is 1.2 times faster than that of the resin for forming the lens material 117M. The front-end resin of the lens material 117M, that is, photosensitive resin layer 117 serves to form the micro lens 115 having no surface roughness and narrow gap. Therefore, the numerical aperture of the micro lens 115 is improved. The etching rate of the resin forming the lens material 117M is the same as that of photosensitive resin 117 and lens layer LL. By doing so, the shape of the micro lens 115 is formed to have approximately the same size and shape as the lens material 117M.

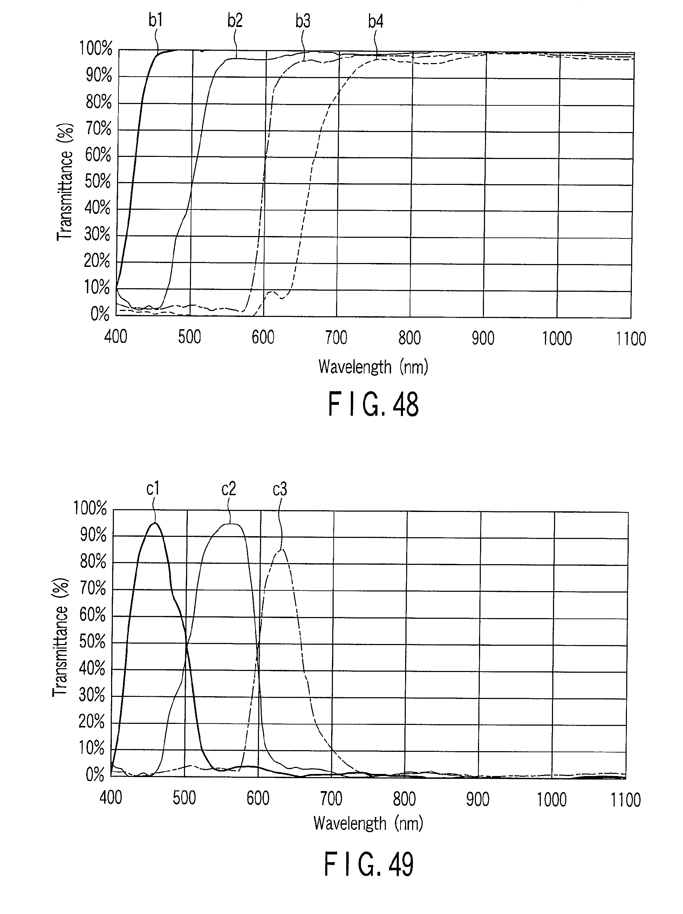

In the imaging device thus configured, transparent, yellow, red and compensating filters 114W, 114Y, 114R and 114Blk have the spectral characteristic shown in FIG. 48. In FIG. 48, b1, b2, b3 and b4 show the spectral characteristic of transparent, yellow, red and compensating filters 114W, 114Y, 114R and 114Blk, respectively. As seen from FIG. 48, the spectral characteristic curve of each filter has the following features. Namely, the transmittance is low in a short-wavelength range, and the rise of the transmittance exists there. Moreover, the transmittance becomes high in a long-wavelength range. Thus, a spectral characteristic curve with an approximately S-shape is obtained.

The foregoing color operations referred to by the equations (5) to (7) are performed. By doing so, it is possible for an imaging device to include virtual blue, green and red filters having the spectral characteristic shown in FIG. 49. In FIG. 49, c1, c2 and c3 show the spectral characteristic of virtual blue, green and red filters, respectively.

The spectral measurement is carried out in the following manner.

First, the thickness of each color filter 114 on the light receiving element 112 and that of transparent layer (planarization layer 113 and lens layer LL) are measured. The thickness of the transparent resin is measured in the following manner. Specifically, a film is formed on a Si substrate, and thereafter, the film thickness is measured using a contact film thickness meter (Dektak IIA made by Sloan Company).

A transparent resin and color filter 114 having the same thickness as measured are formed on a glass substrate. Then, spectral characteristic is measured using a spectrophotometer U-3400 (made by Hitachi Seisakusho). In this case, the glass substrate only (having no color filter and transparent resin) is used as a reference. The spectral characteristic of a color filter and transparent resin only is measured. Moreover, the transmittance value using a transparent glass having a refraction of 1.5 is taken as 100%.

(Example 2)

A thermosetting acrylic resin solution containing benzotriazole dye at a dye concentration at 5% is applied. Then, the solution is coated by spin coating to form planarization layer 113, transparent filter 114W and lens layer LL. An imaging device is manufactured in the same manner as the Example 1 except for the foregoing condition.

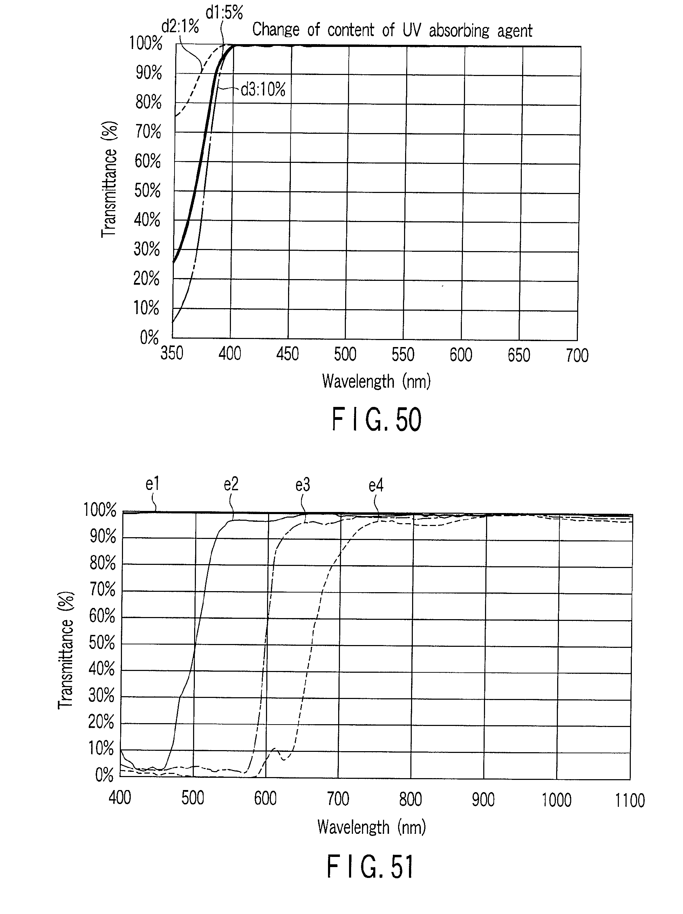

In FIG. 50, d1 shows the spectral characteristic of the transparent resin containing benzotriazole dye at a dye concentration at 5%. For comparison, d2 and d3 show each spectral characteristics of the transparent resins containing benzotriazole dye at dye concentrations of 1% and at 10%.

In the imaging device made in the foregoing manner, e1, e2, e3 and e4 of FIG. 51, show the spectral characteristic of transparent, yellow, red and compensating filters 114W, 114Y, 114R and 114Blk, respectively.

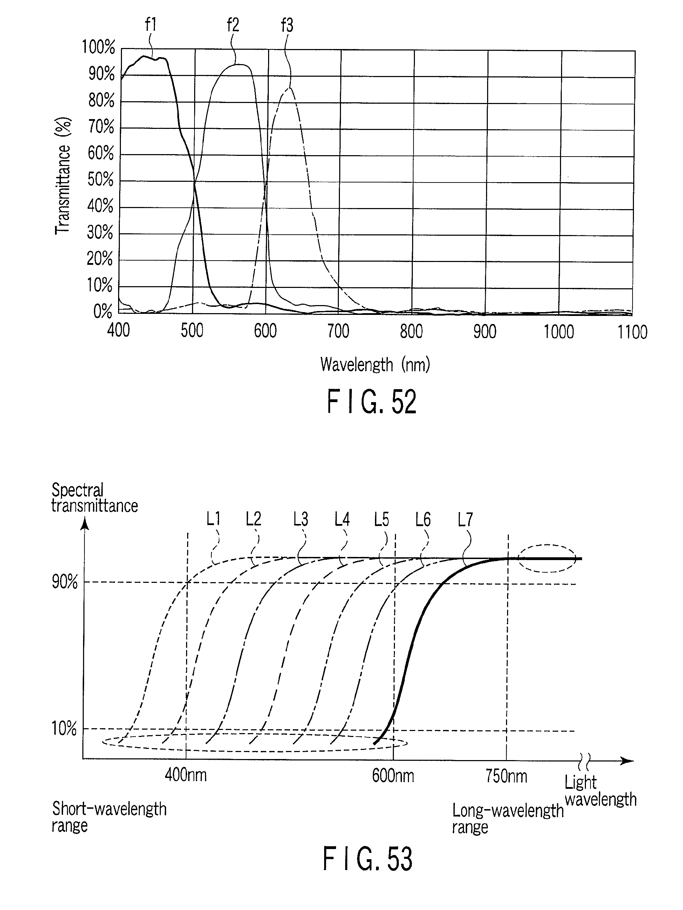

The color operations referred to by the foregoing equations (5) to (7) are performed. By doing so, it is possible to obtain an imaging device having virtual blue, green and red filters having the spectral characteristic shown in FIG. 52. In FIG. 52, f1, f2 and f3 show the spectral characteristic of virtual blue, green and red filters, respectively.

As described above, the spectral characteristic of the transparent resin layer (planarization layer 113, transparent filter 114W, lens layer LL) is changed. By doing so, the transparent filter 114W has a transmittance of 50% on a short-wavelength side is set. Thus, it is possible to select the color characteristic (color close to actual visual sensitivity, the same color as an organic pigment).

Incidentally, the following is given as the secondary effect. Namely, it is possible to prevent halation occurring due to reflection of the pattern exposure light when forming color filters via the photolithography process. Therefore, a color filter having a high resolution is formed.

According to Example 2, an influence of infrared rays is removed by the operation using the compensating filter 114Blk. Therefore, no infrared cut filter is required.

An imaging device using no compensating filter 114Blk is manufactured by the same method without considering an influence of infrared rays in view of simplifying the process of manufacturing the imaging device. In this case, the infrared cut filter must be used; however, the following merit is given. In photolithography including pattern exposure and development, two-time coloring of a color resist for forming yellow and red filters 114Y and 114R is carried out. This serves to reduce the number of processes. Moreover, the transparent filter and micro lens are integrated, and thereby, a process is further omitted. On the contrary, three-time coloring is required in order to produce blue, green and red color filters used for a normal imaging device.

<14th embodiment>

The 14th embodiment relates to an imaging device 201, which includes at lest two filters. One is a first filter having an anti-transmission characteristic with respect to light on a short wavelength side from a first wavelength and having a transmission characteristic with respect to light on a long wavelength side from the first wavelength. Another is a second filter having an anti-transmission characteristic with respect to light on a short wavelength side from a second wavelength on the long wavelength side from the first wavelength and having a transmission characteristic with respect to light on a long wavelength side from the second wavelength. According to the 14th embodiment, each filter has an anti-transmission characteristic in a short wavelength range while having a transmission characteristic in a long wavelength range. Preferably, an approximately S-shaped transmittance curve is obtained as the spectral characteristic.

Light incident via the first and second filters is received by first and second light receiving elements, and then, converted into an electric signal.

Specifically, the imaging device 201 includes filters F1 to F7. These filters F1 to F7 have a first wavelength range of a transmittance of 10% or less in a wavelength range from 350 nm to 750 nm. Moreover, filters F1 to F7 have a wavelength range of transmittance of 90% or more in a wavelength range from 450 nm to 1100 nm, which is a long wavelength range from the first wavelength range. The first and second filters are named as such to show that they are related. Filters F1 to F7 are used as the first and second filters.

Filters F1 to F7 are used for showing white (transparent), green blue, yellow green light, yellow, orange, red and infrared (for convenience, black) lights. The spectral characteristic of filters F1 to F7 is shown as L1 to L7 in FIG. 53.

According to the 14th embodiment, filters F1, F4 and F6 are equivalent to transparent, yellow and red filters 2W, 2Y and 2R, respectively.

The following is an explanation about the method of calculating observed data used for reproducing incident light received via filters F1 to F7.

When light is incident on the imaging device 201, the corresponding first and second light receiving elements receive the incident light via any of filters F1 to F7, that is, first and second filters. The received light is converted into an electric signal.

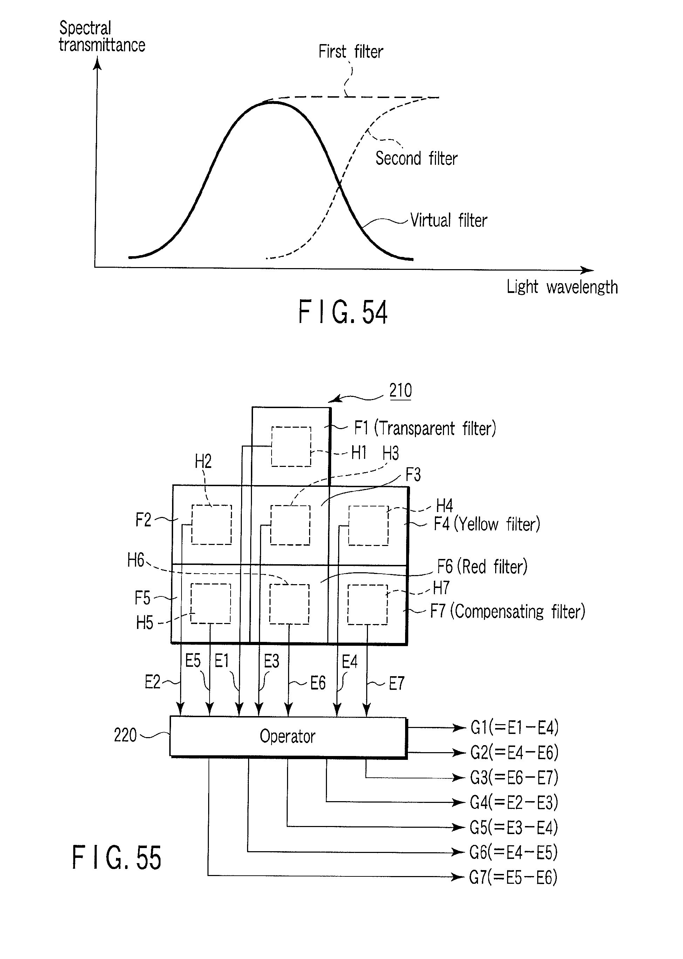

FIG. 54 shows the concept of filters. A wavelength data value DC corresponding to the difference between wavelength ranges of light received by the first and second filters. The wavelength data value DC is calculated from a data value D1 of light received by the first filter and a data value D2 of light received by the second filter.

In other words, the first and second filters form a virtual color filter of the color corresponding to the difference between wavelength ranges.

For example, a blue observed data value Db is obtained based on filter F1 (white) and filter F4 (yellow). A green observed data value Dg is obtained based on filter F4 (yellow) and filter F6 (red). A red data value HDr receiving no influence of infrared ray is obtained from filters F6 (red) and F7 (black).

In the manner descried above, three primary color light data values are obtained, and thus, the received incident light is reproduced.

For example, subtraction of the filter F2 (greenish blue) and the filter F3 (yellow green) is made, and thereby, a green blue (greenish blue) data value is obtained. Subtraction of the filter F3 (yellow green) and the filter F4 (yellow) is made, and thereby, a yellow green data value is obtained. Subtraction of the filter F4 (yellow) and the filter F5 (orange) is made, and thereby, a yellow data value is obtained. Subtraction of the filter F5 (orange) and the filter F6 (red) is made, and thereby, an orange data value is obtained.

In brief, according to the foregoing method, two of filters F1 to F7 forming the first and second filters are used, and thereby, the received incident light is reproduced, and in addition, a finer color is extracted.

According to the 14th embodiment, filters F1 to F7 are given as an example. However, the present invention is not limited to the above. Any color filters may be used so long as they have the foregoing characteristic. Namely, color filters that have the first wavelength range showing a transmittance of 10% or less in a wavelength range from 350 nm to 750 nm are used. Moreover, the color filters have a wavelength range of transmittance of 90% or more in a wavelength range from 450 nm to 1100 nm, which is a long wavelength range from the first wavelength range.

The imaging device of the 14th embodiment is manufactured in the following manner. Namely, of color filters, the color filter having a high color material content is formed using dry etching. Color filters having a low content, except for filters having a high content, are formed using the photolithography process.

<15th embodiment>

According to the 15th embodiment, the transmittance of several filters, that is, color, compensating and transparent filters each rises (increases) in the different wavelength range.

FIG. 55 is a front view showing an imaging device according to a 15th embodiment. In FIG. 55, there is shown a state that filters F1 to F7 of an imaging device 210 are arrayed when viewing them from the light incident side. The filters F1 to F7 includes color, compensating and transparent filters.

Light receiving elements (photo-electrical converting element) H1 to H7 receive incident light via filters F1 to F7, respectively, and then, output observed data values E1 to E7 to an operator 62.

The operator 220 executes subtraction based on observed data values observed via arbitrary two filters of observed data values E1 to E7 of several light receiving elements H1 to H7 observed via filters F1 to F7. Then, the operator 220 calculates an observed data value of light in the wavelength range corresponding to the pair of the foregoing arbitrary two filters, and thereafter, outputs the calculated observed data value.

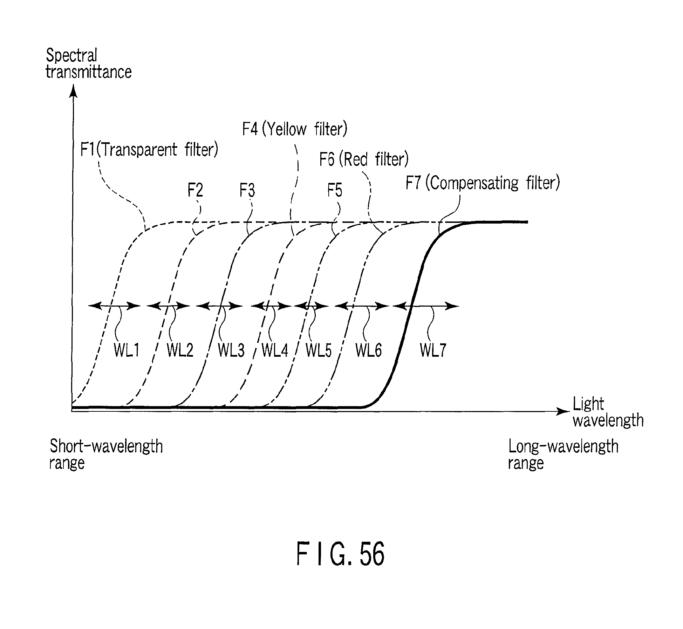

FIG. 56 is a graph showing the relationship between light wavelength and transmittance of filters F1 to F7 included in the imaging device 210.

Filters F1 to F7 included in the imaging device 210 have the following features. Specifically, filters F1 to F7 each have an anti-transmission characteristic of light on a short-wavelength side from wavelengths WL1 to WL7 where the self-transmittance rises. Moreover, filters F1 to F7 each have a transmission characteristic of light on a long-wavelength side from wavelengths WL1 to WL7 where the self-transmittance rises.

In the imaging device 210, light rays incident via filters 1 to F7 are each observed by light receiving elements (photo-electrical converting elements) H1 to H7. The operator 220 inputs observed data values E1 to E7 of light receiving elements H1 to H7.

Filters F1 to F7 each have the following spectra; curve. The transmittance is low in a short-wavelength range from a portion where the self-transmittance rises while being high in a long-wavelength range. Thus, the spectral curve is formed into an approximate S shape. Filters F1 to F7 each have the rise of transmittance in a different wavelength.

According to the 15th embodiment, the filter F1 is a transparent filter (e.g., colorless transparent filter).

The filter F4 is a yellow color filter used for extracting a yellow component of light.

The filter F6 is a red color filter used for extracting a red component of light.

The filter F7 is a compensating filter having an anti-transmission characteristic of light in a visual light wavelength range and a transmission characteristic in a long-wavelength range from the visual light wavelength range.

Considering the characteristic between light transmittance and wavelength, the wavelength WL2 where the transmittance of the filter F2 rises exists between wavelengths WL1 and WL3. The WL1 is a wavelength of a portion where the transmittance of the filter (transparent filter) F1 rises. The WL3 is a wavelength of a portion where the transmittance of the filter F3 rises. For example, the wavelength WL2 where the transmittance of the filter F2 rises divides a wavelength range between WL1 and WL3 into two. Of course, the WL1 is a wavelength of a portion where the transmittance of the filter (transparent filter) F1 rises. The WL3 is a wavelength of a portion where the transmittance of the filter F3 rises.

Likewise, considering the characteristic between light transmittance and wavelength, the wavelength WL4 where the transmittance of the filter (yellow filter) F4 rises exists between wavelengths WL3 and WL6. The WL3 is a wavelength of a portion where the transmittance of the filter F3 rises. The WL6 is a wavelength of a portion where the transmittance of the filter (red filter) F6 rises.

Likewise, the wavelength WL5 where the transmittance of the filter F5 rises exists between wavelengths WL4 and WL6. The WL4 is a wavelength of a portion where the transmittance of the filter F4 rises. The WL6 is a wavelength of a portion where the transmittance of the filter (red filter) F6 rises.

Considering the characteristic between light transmittance and wavelength, the wavelength WL 4 where the transmittance of the filter F4 (yellow filter) rise increases on a short-wavelength side from the wavelength WL5. Of course, the WL5 is a wavelength of a portion where the transmittance of the filter F5 rises. For example, wavelengths WL4 and WL5 divide a wavelength range between WL3 and WL6 into three. Of course, the WL3 is a wavelength of a portion where the transmittance of the filter F3 rises. The WL6 is a wavelength of a portion where the transmittance of the filter (red filter) F6 rises.

As described above, the operator 220 executes subtraction based on observed data values observed via arbitrary two filters of observed data values E1 to E7 of light receiving elements H1 to H7 observed via filters F1 to F7. Then, the operator 220 calculates an observed data value of light in the wavelength range corresponding to the pair of the foregoing arbitrary two filters.

For example, the operator 220 subtracts the observed data value E4 observed via the filter (yellow filter) F4 from the observed data value E1 observed via the filter (transparent filter) F1. Then, the operator 220 outputs a blue observed data value G1.

The operator 220 subtracts the observed data value E6 observed via the filter (red filter) F6 from the observed data value E4 observed via the filter (yellow filter) F4. Then, the operator 220 outputs a green observed data value G2.

The operator 62 subtracts the observed data value E7 via the compensating filter F7 from the observed data value E6 observed via the filter (red filter) F6. Then, the operator outputs a red observed data value G3 removing an influence (component) of infrared ray.

The operator 220 subtracts the observed data value E3 via the filter F3 from the observed data value E2 via the filter F2. Then, the operator outputs a greenish blue observed data value G4.

The operator 220 subtracts the observed data value E4 observed via the filter (yellow filter) F4 from the observed data value E3 via the filter F3. Then, the operator outputs a yellow green observed data value G5.

The operator 220 subtracts the observed data value E5 observed via the filter F5 from the observed data value E4 observed via the filter (yellow filter) F4. Then, the operator outputs a yellow observed data value G6.

The operator 220 subtracts the observed data value E6 observed via the filter (red filter) F6 from the observed data value E5 observed via the filter F5. Then, the operator outputs an orange observed data value G7.

Preferably, filters F1 to F7 each have a transmittance of 90% or more when the wavelength of light is in a long-wavelength range from 750 nm. This is due to cutting of the infrared light component so as to highly accurately observe the intensity of the light component that exists within the human range of vision.

There is the case where light receiving elements (photo-electrical converting elements) H1 to H7 have different sensitivities in a short-wavelength range, which is due to different manufacturers.

If an ultraviolet light absorbing agent is added to the filter (transparent filter) F1, preferably, the light wavelength when the transmittance of the filter F1 becomes 50% is in a range from 350 nm to 400 nm (ultraviolet light range). Therefore, it is preferable that the light wavelength when the transmittance of the filters F1 to F7 becomes 50% is 350 nm or more.

On the other hand, if no ultraviolet light absorbing agent is added to the filter (transparent filter) F1, the following conditions are preferably satisfied. Namely, the light wavelength when the transmittance of other filters F2 to F7 except for filter F1 becomes 50% is 400 nm or more. Preferably, the transmittance of the filter F1 becomes 90% or more in the light wavelength of 400 nm or more.

By doing so, it is possible to reduce an influence of the difference in the sensitivity between manufacturing makers of light receiving elements H1 to H7. Thus, the blue observed data value is obtained according to a fixed condition.

The human sense of vision relates to light in a wavelength range of 400 nm to 700 nm; therefore, the sensitivity of the red range must be controlled. In order to obtain a proper red observed data value, the light wavelength when the transmittance becomes 50% is preferably set as 750 nm or less for filters F1 to F7.

From the result of the foregoing study, the following requirements must be satisfied if an ultraviolet light absorbing agent is added to the filter (transparent filter) F1. Preferably, filters F1 to F7 each have a light transmittance of 50% in a wavelength rage from 350 nm, to 700 nm. In addition, these filters F1 to F7 each have a light transmittance of 90% or more on a long-wavelength side from the light wavelength 750 nm.

Moreover, the following requirements must be satisfied if no ultraviolet light absorbing agent is added to the filter (transparent filter) F1. Preferably, filters F2 to F7 except for filter F1 each have a light transmittance of 50% in a wavelength range from 450 nm, to 700 nm. In addition, these filters F2 to F7 each have a light transmittance of 90% or more on a long-wavelength side from the light wavelength of 750 nm. The filter F1 has a light transmittance of 90% or more on a long-wavelength side from the light wavelength of 400 nm.

According to the 15th embodiment, filters F1 to F7 may be provided with a micro lens at the light incident side.

The filter F1 and the micro lens are formed of the same transparent resin.

As described above, filters (e.g., F1 to F7) having the spectral characteristic that the transmittance suddenly increases in different wavelength ranges are properly selected. The selected filter is placed on the light receiving element, and an operation is made based on observed data values obtained from the light receiving elements. By doing so, other observed data values having fine color component are obtained in addition to red (R), green (G) and blue (B).

The compensating filter according the foregoing each embodiment is formed by mixing red pigment and violet pigment. By doing so, the compensating filter is formed to have the transmittance of 50% in the wavelength of about 660 nm.

Moreover, the compensating filter is formed by mixing a red pigment and cyan pigment. By doing so, the compensating filter is formed to have the transmittance of 50% in the wavelength of about 740 nm.

Industrial Applicability

According to the present invention, there is provided an imaging device, which is excellent in color balance and color reproducibility.

**Claims**

1. An imaging device **characterized by** comprising:

   a filter used for extracting a specified color component of an incident light; and
   a light receiving element observing the incident light via the filter,
   the filter including:
   a transparent filter;
   a yellow filter used for extracting a yellow component; and
   a red filter used for extracting a red component.

2. The imaging device according to claim 1, **characterized in that** the light receiving element further includes:

   an incident light receiving element observing the incident light via the transparent filter;
   a yellow light receiving element observing the incident light via the yellow filter;
   a red light receiving element observing the incident light via the red filter;
   operating means for subtracting an observed result observed by the yellow light receiving element from an observed result observed by the incident light receiving element to calculate a blue observed result; and
   operating means for subtracting an observed result observed by the red light receiving element from an observed result observed by the yellow light receiving element to calculate a green observed result.

3. The imaging device according to claim 1 or 2, **characterized by** further comprising:

   a transparent planarization layer forming the transparent filter to cover the yellow and red filters.

4. The imaging device according to claim 3, **characterized by** further comprising:

   a micro lens formed of the transparent planarization layer, and collecting light to the light receiving elements.

5. The imaging device according to any one of claims 1 to 4, **characterized in that** the transparent filter absorbs ultraviolet ray in a short-wavelength range from 400 nm.

6. The imaging device according to any one of claims 1 to 5, **characterized in that** the transparent filter has a spectral characteristic of showing a light transmittance of 50% with respect to light having any of a wavelength range from 365 nm to 420 nm and having a light transmittance of 90% or more in a wavelength of 450 nm.

7. The imaging device according to any one of claims 1 to 6, **characterized in that** the transparent filter has a spectral characteristic of showing a light transmittance of 50% with respect to light having any of a wavelength range from 390 nm to 420 nm and having a light transmittance of 90% or more in a wavelength of 450 nm.

8. The imaging device according to any one of claims 1 to 7, **characterized in that** the transparent filter, the yellow filter and the red filter are adjacently arrayed like a mesh to form one unit of color separation, and
the number of pixels of the yellow filter is equal to the total number of pixels of the transparent filter and the red filter.

9. The imaging device according to any one of claims 1 to 7, **characterized in that** the filter further includes a compensating filter having an anti-transmission characteristic in a visible light wavelength range and a transmission characteristic on a long-wavelength side from the visible light wavelength range.

10. The imaging device according to claim 9, wherein the light receiving element further includes a compensating light receiving element observing the incident light via the compensating filter, and
the device further includes operating means for subtracting an observed result observed by the compensating light receiving element from the observed result observed by the red light receiving element.

11. The imaging device according to claim 9 or 10, wherein the compensating filter has approximately the same level transmission characteristic as the red filter on a long-wavelength side from a visible light wavelength range.

12. The imaging device according to any one of claims 8 to 11, **characterized in that** the difference in light transmittance between the compensating filter and the red filter is in a range of about 5% or less in a light wavelength range from 400 nm to 550 nm and on a long-wavelength range from 750 nm, and
the compensating filter has a light transmittance of 50% in a light wavelength range from 630 nm to 750 nm.

13. The imaging device according to any one of claims 8 to 12, **characterized in that** the compensating filter is formed by optically overlapping several colors.

14. The imaging device according to claim 13, **characterized in that** the compensating filter is formed by optically overlapping two colors, that is, violet and red.

15. The imaging device according to claim 13, **characterized in that** the compensating filter is formed by optically overlapping two colors, that is, cyan and red.

16. The imaging device according to any one of claims 13 to 15, **characterized in that** the compensating filter is formed by stacking several filters.

17. The imaging device according to any one of claims 8 to 16, **characterized in that** the transparent filter, the yellow filter, the red filter and the compensating filter are adjacently arrayed like a mesh to form one unit of color separation.

18. The imaging device according to any one of claims 8 to 17, **characterized in that** the compensating filter has a transmittance of 5% or less with respect to light having a wavelength range from 400 nm to 550 nm, and has a transmittance of 50% with respect to light having any of a wavelength range from 620 nm to 690 nm, and further, has a transmittance of 70% or more with respect to light having a wavelength of 700 nm.

19. The imaging device according to any one of claims 8 to 18, **characterized in that** the compensating filter is formed of a colored resin compound containing at least pigments of C.I. Pigment Violet 23 and, C.I. Pigment Yellow 139.

20. The imaging device according to any one of claims 8 to 19, **characterized in that** the compensating filter is formed of a colored resin compound containing at least pigments of C.I. Pigment Violet 23, C.I. Pigment Yellow 139 and C.I. Pigment Red 254.

21. The imaging device according to any one of claims 1 to 20, **characterized by** further comprising:

a substrate provided with the light receiving element,
the substrate being provided with a light shield film for preventing reflection and transmission of light except the incident light, which is incident on the light receiving element, the light shield film being provided on an area on the substrate other than an area where the incident light is incident on the light receiving element.

22. The imaging device according to claim 21, **characterized in that** the light shield film has an ultraviolet absorbing function.

23. The imaging device according to claim 21 or 22, **characterized in that** the light shield film has an infrared absorbing function.

24. The imaging device according to any one of claims 21 to 23, **characterized in that** the light shield film is stacked with a film having at least one of a ultraviolet absorbing function and a near-infrared absorbing function.

25. An imaging device including several photo-electric converting elements receiving an incident light via several filters, **characterized by** comprising:

a first filter being one of said several filters, and being an arbitrary filter included in said several filters, and further, having an anti-transmission characteristic with respect to light on a short-wavelength side from a first wavelength and a transmission characteristic with respect to light on a long-wavelength side from the first wavelength;
a second filter being another filter different from the first filter of said several filters, and having an anti-transmission characteristic with respect to light on a short-wavelength side from a second wavelength, which is a long-wavelength side from the first wavelength, and a transmission characteristic with respect to light on a long-wavelength side from the second wavelength;
a first photo-electric converting element being one of said several photo-electric converting elements, and receiving an incident light via the first filter;
a second photo-electric converting element being another photo-electric converting element different from the first photo-electric converting element, and receiving the incident light via the second filter; and
operating means for subtracting an observed data value of light observed by the second photo-electric converting element from an observed data value of light observed by the first photo-electric converting element to calculate an observed data value of light of a color corresponding to the difference in a wavelength range between the first and second filters.

26. The imaging device according to claim 25, **characterized in that** the first wavelength is any of a wavelength range 350 nm to 750 nm.

27. The imaging device according to claim 25 or 26, **characterized in that** the first filter is a transparent filter having a light transmittance of 90% or more on a long-wavelength side from light wavelength of 400 nm,
of said several filters, a filter having a characteristic such that the light transmittance rises at the most long-wavelength side is a compensating filter having an anti-transmission characteristic in a visible light wavelength range and having transmission characteristic on a long-wavelength side from the visible light wavelength range,
other filters except the compensating filter each have a light transmittance of 50% in a light wavelength range from 350 nm to 750 nm, and each have a light transmittance of 90% or more on a long-wavelength side from a light wavelength of about 750 nm.

28. An imaging device **characterized by** comprising:

an imaging element detecting an intensity value of light having a specified wavelength range of an incident light; and
operating means for reproducing the incident light based on the intensity value of light detected by the imaging element,
the imaging element including:
a semiconductor substrate;
a photo-electric converting element formed on the semiconductor substrate, and receiving an incident light;
a transparent filter formed on the photo-electric converting element, and transmitting the incident light;
a red filter formed on the photo-electric converting element, and used for extracting a red component of the incident light;
a yellow filter formed on the photo-electric converting element, and used for extracting a yellow component of the incident light;
a transparent resin layer formed to cover the color filters; and
a micro lens formed on the color filters,
the operating means including:
means for subtracting an intensity value of the incident light received via the yellow filter from an intensity value of the incident light received via the transparent filter to calculate a blue component value of the incident light; and
means for subtracting an intensity value of the incident light received via the red filter from an intensity value of the incident light received via the yellow filter to calculate a green component value of the incident light.

**29.** The imaging device according to claim 28, **characterized in that** the imaging element further includes a compensating filter used for extracting an infrared component of the incident light, and
the operating means further includes means for subtracting an intensity value of the incident light received via the compensating filter from an intensity value of the incident light received via the red filter to calculate a red component value of the incident light.

Exposure wavelength 365 nm

F I G. 1 (PRIOR ART)

F I G. 2 (PRIOR ART)

31

F I G. 3
(PRIOR ART)

FIG. 4

F I G. 5

F I G. 6

FIG.7

F I G. 8

FIG. 9

FIG. 10

FIG. 11

F I G. 12

F I G. 13

F I G. 14

2Y  12W  2Y  12W

6

5

3Y  3W  3Y  3W

11

# F I G. 15

20

17

19

18

# F I G. 16

2W 2Y 3Y 3R 3W 2W 2R 2Y

3Blk 2Blk 1

3W 3Y

2Blk

III 2R III'

3R 3Blk

2W 2W

3W 2Y

2Y 3Y

3Y 3R

2Blk

2R 2Blk 3W 2R 3Blk Dy Dblk

3R 3Blk Dw

Dr

**FIG. 17**

4B | Blue operating unit → Blue observed data value $Db=(Dw-Dy)$

4G | Green operating unit → Green observed data value $Dg=(Dy-Dr)$

4R | Red operating unit → Compensated red observed data value $HDr=(Dr-Dblk)$

Operator ~4

FIG. 18

FIG. 19

F I G. 20

F I G. 21

F I G. 22

F I G. 23

F I G. 24

F I G. 25

F I G. 26

F I G. 27

F I G. 28

F I G. 29

F I G. 30

F I G. 31

FIG. 32

Operator

Blue operating unit — 121B → Blue observed data value

Green operating unit — 121G → Green observed data value

Red operating unit — 121R → Red observed data value

120

110

112Y 114Y 114W 112W 112R 114Y 114R 112Y 114W 112W 112R 114Y 114R 112Y 114W 112W 114Y 112Y

112Y 114Y 114R 112R 114Y 112Y 114W 112W 114R 112R 114Y 112Y 114W 112W 114R 112R 114Y 112Y

V V' VI VI'

| W | Y | W | Y |
|---|---|---|---|
| Y | R' | Y | R' |
| W | Y | W | Y |
| Y | R' | Y | R' |

FIG. 33

115    114W    115    114Y    115    114W    115    114Y

113

111

112W    112Y    112W    112Y    110

F I G. 34A

115    114Y    115    114R    115    114Y    115    114R

113

111

112Y    112R    112Y    112R    110

F I G. 34B

```
              ┌──────────────┐
              │    Start     │
              └──────┬───────┘
                     │
                     ▼
        ┌──────────────────────────────┐
        │ Receive light from observed object │──── S1
        └──────────────┬───────────────┘
                       │
                       ▼
        ┌──────────────────────────────┐
        │ Extract each color component of │──── S2
        │ W, Y and R                     │
        └──────────────┬───────────────┘
                       │
                       ▼
        ┌──────────────────────────────┐
        │ Each light receiving element photo- │
        │ electrically converts light into   │──── S3
        │ electric signal                    │
        └──────────────┬───────────────┘
                       │
                       ▼
        ┌──────────────────────────────┐
        │ Operate R, G and B light data  │──── S4
        └──────────────┬───────────────┘
                       │
                       ▼
        ┌──────────────────────────────┐
        │ Synthesize color image         │──── S5
        └──────────────┬───────────────┘
                       │
                       ▼
              ┌──────────────┐
              │    End       │
              └──────────────┘
```

## F I G. 35

F I G. 36

FIG. 37A

FIG. 37B

FIG. 37C

114W 114Y 114W 114Y

F I G. 37D

114W 114Y 114W 114Y

LL

113

111

112W 112Y 112W 112Y

F I G. 38A

116

F I G. 38B

FIG. 38C

117

FIG. 38D

117M    117M    117M    117M

FIG. 38E

115    115    115    115

110

115   115   115   115
114W   114Y   114W   114Y

113
111

112W   112Y   112W   112Y   110A

F I G. 39

115   115   115   115
114W   114Y   114W   114Y

111

112W   112Y   112W   112Y   110B

F I G. 40

F I G. 41

| W | Y | W | Y |
|---|---|---|---|
| R' | Blk | R' | Blk |
| W | Y | W | Y |
| R' | Blk | R' | Blk |

FIG. 42

F I G. 43A

F I G. 43B

F I G. 44

F I G. 45

F I G. 46

a2:1% Change of content of UV absorbing agent

F I G. 47

F I G. 48

F I G. 49

F I G. 50

F I G. 51

F I G. 52

F I G. 53

Spectral transmittance

First filter

Second filter

Virtual filter

Light wavelength

FIG. 54

<u>210</u>

F1 (Transparent filter)

H1  H3

H2

F3

H4

F4 (Yellow filter)

F2

F6 (Red filter)

H6

H7

F5

F7 (Compensating filter)

H5

E5  E1  E3  E4

E2

E6  E7

220  Operator

G1(=E1−E4)

G2(=E4−E6)

G3(=E6−E7)

G4(=E2−E3)

G5(=E3−E4)

G6(=E4−E5)

FIG. 55

G7(=E5−E6)

F I G. 56

## INTERNATIONAL SEARCH REPORT

| | International application No. |
|---|---|
| | PCT/JP2006/309594 |

A. CLASSIFICATION OF SUBJECT MATTER
*H01L27/14*(2006.01)i, *G02B5/20*(2006.01)i, *H04N5/335*(2006.01)i, *H04N9/07*
(2006.01)i

According to International Patent Classification (IPC) or to both national classification and IPC

B. FIELDS SEARCHED

Minimum documentation searched (classification system followed by classification symbols)
*H01L27/14, G02B5/20, H04N5/335, H04N9/07*

Documentation searched other than minimum documentation to the extent that such documents are included in the fields searched
| | | | |
|---|---|---|---|
| Jitsuyo Shinan Koho | 1922-1996 | Jitsuyo Shinan Toroku Koho | 1996-2006 |
| Kokai Jitsuyo Shinan Koho | 1971-2006 | Toroku Jitsuyo Shinan Koho | 1994-2006 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | JP 59-099762 A (Nippon Kogaku Kogyo Kabushiki Kaisha), 08 June, 1984 (08.06.84), Full text; all drawings (Family: none) | 1-29 |
| A | JP 63-301904 A (Sharp Corp.), 08 December, 1988 (08.12.88), Full text; all drawings (Family: none) | 1-29 |
| A | JP 63-266872 A (Hitachi, Ltd.), 02 November, 1988 (02.11.88), Full text; all drawings (Family: none) | 1-29 |

| ☒ Further documents are listed in the continuation of Box C. | ☐ See patent family annex. |
|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 24 July, 2006 (24.07.06) | 01 August, 2006 (01.08.06) |

| Name and mailing address of the ISA/ | Authorized officer |
|---|---|
| Japanese Patent Office | |
| Facsimile No. | Telephone No. |

Form PCT/ISA/210 (second sheet) (April 2005)

<table>
<tr><td colspan="2" align="center">**INTERNATIONAL SEARCH REPORT**</td><td>International application No.<br>PCT/JP2006/309594</td></tr>
</table>

C (Continuation).   DOCUMENTS CONSIDERED TO BE RELEVANT

| Category* | Citation of document, with indication, where appropriate, of the relevant passages | Relevant to claim No. |
|---|---|---|
| A | JP 05-206429 A  (Toshiba Corp.),<br>13 August, 1993 (13.08.93),<br>Full text; all drawings<br>& US 5466926 A | 1-29 |
| A | JP 2000-338393 A  (Olympus Optical Co., Ltd.),<br>08 December, 2000 (08.12.00),<br>Full text; all drawings<br>& US 6816199 B1 | 1-29 |

Form PCT/ISA/210 (continuation of second sheet) (April 2005)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2002051350 A
- JP 2000019322 A
- JP 63073204 A